(19) **Europäisches Patentamt**

**European Patent Office**

**Office européen des brevets**

(11) **EP 1 024 522 A1**

(12) **EUROPEAN PATENT APPLICATION**
published in accordance with Art. 158(3) EPC

(43) Date of publication:
02.08.2000 Bulletin 2000/31

(51) Int. Cl.$^7$: **H01L 21/027**, G03F 7/20

(21) Application number: 98933919.7

(86) International application number:
**PCT/JP98/03305**

(22) Date of filing: 24.07.1998

(87) International publication number:
**WO 99/05709 (04.02.1999 Gazette 1999/05)**

(84) Designated Contracting States:
**AT BE CH CY DE DK ES FI FR GB GR IE IT LI LU MC NL PT SE**

(30) Priority: 24.07.1997 JP 19815497

(71) Applicant: **Nikon Corporation**
**Tokyo 100-8831 (JP)**

(72) Inventor:
**NISHI, Kenji,**
**Nikon Corporation**
**Tokyo 100-8331 (JP)**

(74) Representative: **Cole, Paul**
**Lucas & Co.,**
**135 Westhall Road**
**Warlingham, Surrey CR6 9HJ (GB)**

(54) **EXPOSURE METHOD AND ALIGNER**

(57) Attention is paid to the phenomenon that a static image distortion characteristic is averaged in the width of a projection area in a scanning direction and becomes a dynamic image distortion characteristic, when a mask pattern is scan-exposed onto a photosensitized substrate by a projection exposure apparatus. At least a random component included in the dynamic image distortion characteristic is corrected by arranging an image correction plate obtained by locally polishing the surface of a transparent parallel plate. Correction plates which minimize other aberrations beforehand are manufactured and installed within a projection optical path, considering that also the other aberrations are averaged and become dynamic aberration characteristics at the time of scan-exposure.

In this way, an exposure apparatus for reducing respective aberration types caused by an illumination optical system within an projection optical system of the projection exposure apparatus using an ultraviolet illumination light is provided.

FIG. 1

EP 1 024 522 A1

## Description

### Technical Field

The present invention relates to an exposure method and apparatus for accurately exposing a sensitized substrate with a pattern formed on a mask through a projection optical system, and is particularly preferable for a scan-exposure method used in a lithography process for manufacturing a circuit device such as a semiconductor circuit element, a liquid crystal display element, etc.

### Background Art

Currently, on a semiconductor device manufacturing scene, a step-and-scan projection exposure apparatus which scan-exposes the whole of a circuit pattern of a reticle to one shot area on a wafer, by using an ultraviolet pulse laser beam having a wavelength of 248 nm from a KrF excimer laser light source or an ultraviolet pulse laser beam having a wavelength of 193 nm from an ArF excimer laser light source as an illumination light, and by performing one-dimensional scanning for a reticle (original version, mask substrate) and a semiconductor wafer, on which a circuit pattern is drawn relatively to a projection field of a reduction projection lens system, is a promising exposure apparatus for manufacturing a circuit device.

Such a step-and-scan projection exposure apparatus has been commercialized and marketed as a micra-scan exposure apparatus which is equipped with a reduction projection optical system composed of a dioptric element (lens element) and a catoptric element (concave mirror, etc.), and is provided by Perkin Elmer Corporation. As explained in detail, for example, on pp. 424-433 in Vol. 1088 of SPIE in 1989, the micra-scan exposure apparatus exposes a shot area on a wafer by scanning and moving a reticle and the wafer at a speed rate according to a projection magnification (reduced to one-fourth) while projecting part of the pattern of the reticle onto the wafer through an effective projection area restricted to an arc slit shape.

Additionally, as a step-and-scan projection exposure method, a method combined with the method which uses an excimer laser light as an illumination light, restricts to a polygon (hexagon) the effective projection area of a reduced projection lens system having a circular projection field, and makes both ends of the effective projection area in a non-scanning direction partially overlap, what is called, a scan-and-stitching method is known, for example, by the Japanese laid-open Publication No. 2-229423 (Jain). Additionally, examples of a projection exposure apparatus adopting such a scan-exposure method are disclosed also by the Japanese laid-open Publications No. 4-196513 (NC:Nishi), No. 4-277612 (NC:Nishi), No. 4-277612 (NC:Nishi), No. 4-307720 (NC:Ota), etc.

With the apparatus which restricts an effective projection area of a projection optical system to an arc or a rectilinear slit shape among projection exposure apparatuses of a scan-exposure type, an image distortion of a pattern transferred onto a wafer as a result of scan-exposure depends on each aberration type of the projection optical system itself or an illumination condition of an illumination optical system as a matter of course. Such an image distortion became an important error budget also for a stepper of a method (stationary exposure method) with which a circuit pattern image on a reticle, which is included in a projection field, is collectively transferred in a shot area on a wafer in a state where a mask and the wafer are made stationary.

Additionally, the Japanese laid-open Publication No. 6-349702 (Nikon) discloses the method for adjusting aberration characteristics of a projection optical system by rotating some of lens elements configuring the projection optical system about an optical axis in order to improve the image distortion characteristic occurring in a resist image on a photosensitized substrate, which is transferred by scan-exposure. Furthermore, as disclosed by the Japanese laid-open Publications No. 4-127514 (NC:Taniguchi) and No. 4-134813 (N:shiraishi), it is also known that a projection magnification, a distortion aberration, etc. are adjusted by infinitesimally moving some of lens elements configuring a projection optical system.

However, there is a problem in that even if an aberration characteristic is adjusted by rotating some of lens elements configuring a projection optical system or by decentering or tilting an optical axis, this does not always guarantee that a satisfactory aberration characteristic (image distortion characteristic) can be obtained. Furthermore, it is difficult to partially adjust and modify respective characteristics such as a local image distortion, etc. within a projection area.

The present invention was developed in the above described background. A first object of the present invention is to provide an exposure method and apparatus which can accurately expose a substrate with a pattern formed on a mask.

A second object of the present invention is to provide an exposure method and apparatus which can form a mask pattern image on a substrate in a desired state.

A third object of the present invention is to provide an exposure method and apparatus which comprises an optical correction element suitable for a scan-exposure method, and can easily reduce a projection aberration occurring at the time of scan-exposure.

### Disclosure of Invention

According to one aspect of the present invention, a pattern of a mask (R) is scan-exposed onto a substrate (W) by moving the mask(R) and the substrate (W) in a scanning direction in a state where the mask (reticle R) is arranged on an object plane side of a projection optical system (PL) having a predetermined image formation characteristic, the substrate (wafer W) is arranged on its image plane side, a partial image of the mask (R) which is projected onto the image plane side is restricted to within a projection area (EIA) having a predetermined width in a one-dimensional scanning direction, and at least one optical correction element (an image distortion correction plate G1, an astigmatism/coma correction plate G3, or an image plane curvature correction plate G4), which is optically processed so that an average aberration characteristic obtained by averaging the projection aberrations of respective images at a plurality of image points existing in sequence in the scanning direction becomes a predetermined state at each of a plurality of positions in a non-scanning direction intersecting the scanning direction of the projection area (EIA), is arranged in an image formation optical path by a projection optical system (PL).

According to the present invention of the above described configuration, it becomes possible to satisfactorily correct projection aberrations influenced by the aberrations of both of an illumination optical system and a projection optical system, especially, a dynamic distortion characteristic, an astigmatism characteristic, a coma characteristic, and an image plane curvature characteristic at the time of scan-exposure, thereby accurately exposing a mask pattern onto a substrate.

According to another aspect of the present invention, in an exposure method for exposing a substrate (W) by projecting a pattern of a mask (R) onto the substrate (W) through a projection optical system (PL), a mask pattern image is projected through the projection optical system in a state where the mask (R) and the substrate (W) are arranged, and an astigmatism correction plate (G3) for correcting a random astigmatism characteristic of each image at a plurality of positions within a projection area (EIA) of the projection optical system is arranged between the mask (R) and the substrate (W) in order to expose the substrate.

According to the present invention, it becomes possible to satisfactorily correct a random astigmatism characteristic within a projection area, thereby accurately exposing a mask pattern onto a substrate.

According to a further aspect of the present invention, in an exposure method for exposing a substrate (W) by projecting a pattern of a mask (R) onto the substrate (W) through a projection optical system (PL), a mask pattern image is projected through a projection optical system in a state where the mask (R) and the substrate (W) are arranged, and a coma correction plate (G3) for correcting a random coma characteristic of each image at a plurality of positions within a projection area (EIA) of the projection optical system (PL) is arranged between the mask (R) and the substrate (W) in order to expose the substrate.

According to the present invention, it becomes possible to satisfactorily correct a random coma characteristic within a projection area, thereby accurately exposing a mask pattern onto a substrate.

**Brief Description of Drawings**

Fig. 1 is a schematic showing the detailed configuration of the main body of a projection exposure apparatus.
Fig. 2 shows one example of a telecentric error of a projection optical system, which is measured by a image detector.
Fig. 3 is a partial sectional view showing the state of an astigmatism/coma correction plate arranged on an image plane side of a projection optical system, and an image plane curvature correction plate.
Fig. 4 is a schematic explaining a difference of a numerical aperture according to an image height of image formation luminous flux (or illumination luminous flux) projected onto a projection image plane side through a projection optical system.
Fig. 5 is a schematic showing the structure of a measurement sensor for measuring an NA difference according to an image height of the illumination luminous flux, and its processing circuit.
Fig. 6 is a schematic illustratively showing examples of a light source image within an illumination optical system, which is measured by the measurement sensor shown in Fig. 5.
Fig. 7 is a schematic explaining an optical path from a fly-eye lens configuring an illumination optical system to an illuminated plane, and an NA difference of an illumination light focusing on one point on the irradiated surface.
Fig. 8 is a schematic showing the arrangement of an illumination NA correction plate for correcting an NA difference according to an image height of an illumination light, and is a top view showing the structure of the correction plate.
Fig. 9 is a schematic illustratively explaining the exchange and the adjustment mechanisms of aberration correction plates of respective types installed in a projection exposure apparatus.
Fig. 10 is a schematic illustratively explaining another types of a projection optical system to which the present invention is applied.
Fig. 11 is a schematic showing the array of shot areas on a wafer onto which a test reticle pattern is scanned and exposed at the time of test printing, and the state of one shot area within the array.
Fig. 12 is a schematic explaining the state where respective projection images of a measurement mark pattern within one shot area, which is test-printed, are grouped and averaged.

**Best Mode for Carrying out the Invention**

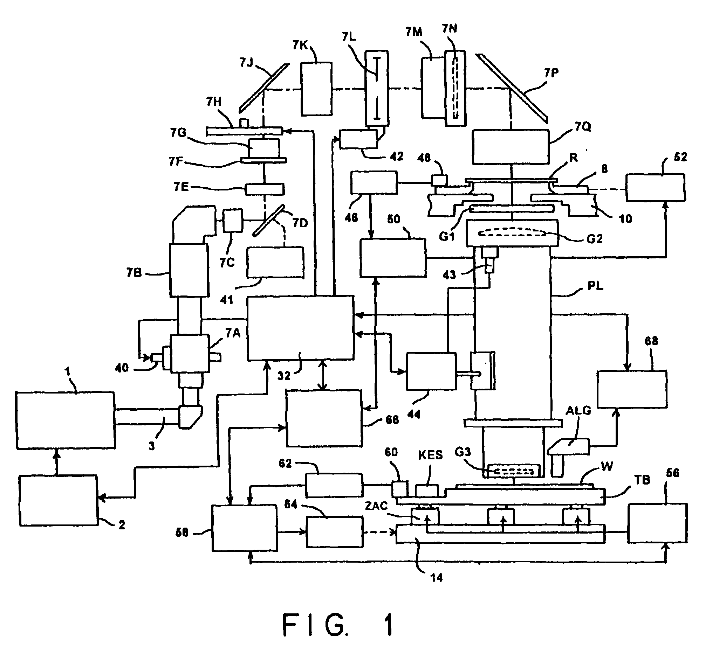

The entire configuration of a projection exposure apparatus which is preferable for practicing the present invention is explained by referring to Fig. 1. A projection exposure apparatus shown in Fig.1 is intended to transfer the whole of a circuit pattern of a reticle in respective shot areas on a wafer W with a step-and-scan method by relatively scanning the reticle and the wafer W in a one-dimensional direction against a field of a projection optical system PL while projecting a partial image of the circuit pattern drawn on the reticle as a mask substrate onto the semiconductor wafer W as a photosensitized substrate through the projection optical system PL. In Fig. 1, it is assumed that the optical axis direction of the projection optical system PL is Z direction, the scanning direction of the reticle R on the plane vertical to the optical axis of the projection optical system PL is Y direction, and the direction vertical to the scanning direction of the reticle R is X direction.

In Fig. 1, after an ultraviolet pulse light output from an excimer laser light source 1 passes through a tube 3 and is adjusted to be a predetermined peak intensity by a variable beam attenuator 7A, it is modified to be a predetermined sectional shape by a beam modifier 7B. The sectional shape is set to be similar to the entire shape of an entrance of a first fly-eye lens system 7C for making the intensity distribution of an illumination light even. Note that the excimer laser light source 1 pulse-emits, representatively, a KrF excimer laser beam having a wavelength of 248 nm or an ArF excimer laser beam having a wavelength of 193 nm.

Additionally, examples of an exposure apparatus which uses excimer laser as a light source are disclosed by the Japanese laid-open Publications No. 57-198631 (IBM), No. 1-259533 (NC: Ichihara), No. 2-135723 (NC: Hazama), No. 2-294013 (NC: Uemura), etc., while examples of an exposure apparatus which uses an excimer laser light source for step-and-scan exposure are disclosed by the Japanese laid-open Publications No. 2-229423, No. 6-132195, No. 7-142354, etc. Accordingly, also to the exposure apparatus shown in Fig. 1, the fundamental techniques disclosed by the above described publications can be applied as they are or by being partially modified.

An ultraviolet pulse light emitted from many point light sources, which is generated on an exit side of the first fly-eye lens system 7C, enters a second fly-eye lens system 7G via a vibration mirror 7D for smoothing interference fringes or a weak speckle occurring on an irradiated plane (a reticle plane or a wafer plane), a collective lens system 7E, an illumination NA correction plate 7F for adjusting the directionality (illumination NA difference) of a numerical aperture on the plane irradiated by an illumination light. The second fly-eye lens system 7G configures a double fly-eye lens system together with the first fly-eye lens system 7C and the collective lens system 7E. The configuration where such a double fly-eye lens system and the vibration mirror 7B are combined is disclosed in detail, for example, by the Japanese laid-open Publications No. 1-235289 (NC: Ichihara) and No. 7-142454 (NC: Ozawa).

On the exit side of the second fly-eye lens system 7G, a switch-type illumination σ diaphragm plate 7H for restricting the shape of a light source plane to an annular shape, a small circle, a large circle, etc. or for forming a four separated light source planes is arranged. The ultraviolet pulse light passing through the diaphragm plate 7H is reflected by a mirror 7J, and irradiates the aperture of an illumination field diaphragm (reticle blind) 7L by a collective lens 7K with an uniform intensity distribution.

Note that, however, interference fringes or a weak speckle with a contrast of several percent depending on the coherency of the ultraviolet pulse light from the excimer laser light source 1 may be superposed on the intensity distribution.

Accordingly, on the wafer plane, exposure amount unevenness may occur due to the interference fringes or weak speckle. However, the exposure amount unevenness is smoothed by vibrating the vibration mirror 7D in synchronization with the moving of the reticle or the wafer W at the time of scan-exposure and the oscillation of an ultraviolet pulse light, as disclosed by the above described patent publication No. 7-142354.

The ultraviolet pulse light which passes through the aperture of the reticle blind 7L in this way is irradiated on the reticle R via a collective lens system 7M, an illumination telecentric correction plate (a quartz parallel plate which can be tilted) 7N, a mirror 7P, and a main condenser lens system 7Q. At that time, an illumination area similar to the aperture of the reticle blind 7L is formed on the reticle R. In this preferred embodiment, the illumination area is defined to be a slit shape or a rectangular shape, which extends in the direction orthogonal to the moving direction of the reticle R at the time of scan-exposure. If the width of the shading band in the periphery of a circuit pattern on the reticle is desired to be narrowed or if the scan moving stroke of the reticle is desired to be reduced as short as possible, it is desirable that the mechanism for changing the width of the scanning direction of the reticle blind during scan-exposure is arranged, for example, as recited in the Japanese laid-open Publication No. 4-196513.

The aperture of the reticle blind 7L is set to be conjugate to the reticle R by the collective lens system 7M and the condenser lens system 7Q. Also this aperture is formed to be a slit shape or a rectangular shape, which extends in the X direction. By such an aperture of the reticle blind 7L, part of the circuit pattern area on the reticle R is illuminated, and the image luminous flux from the illuminated part of the circuit pattern is reduced to one-fourth or one-fifth and projected onto the wafer W through the projection lens system PL.

In this embodiment, it is assumed that the projection lens system PL is a telecentric system on both of the object plane (reticle R) side and the image plane (wafer W) side, and has a circular projection field. Additionally, the projection lens system PL is assumed to be composed of only a dioptric element (lens element) in this embodiment. However, the projection lens system PL may be a catadioptric system where a dioptric element and a catoptric element are combined, as disclosed by the Japanese laid-open Publication No. 3-282527 (NC).

In a position close to the object plane of his projection lens system PL, a telecentric unit lens system G2 which can infinitesimally move or tilt is arranged. By the movement of the lens system G2, the magnification (the aberration of isotropic distortion) or the aberration of non-isotropic distortion such as a barrel-shaped, a spool-shaped, a trapezoid-shaped distortion, etc. of the projection lens system PL can be adjusted finely. Additionally, in a position close to the image plane of the projection lens system PL, an astigmatism/coma aberration correction plate G3 for reducing an astigmatism aberration or coma aberration, which may frequently occur in an area, which is close to the periphery of a projection field, where an image height of a projection image is especially high, and for especially reducing a random astigmatism or coma aberration.

In this embodiment, an image distortion correction plate G1 for effectively reducing a random distortion component included in a projection image formed on an effective image projection area (stipulated by the aperture portion of the reticle blind 7L) within a circular field, is arranged between the lens system G2 of the projection lens system PL and the reticle R. This correction plate G1 is made by locally polishing the surface of a quartz or fluorite parallel plate having a thickness of approximately several millimeters, and infinitesimally deflects the image luminous flux which passes through the polished portion.

For the respective optical components which configure the above described illumination or projection optical paths, a driving mechanism 40 for switching or continually varying a beam attenuation filter of the variable beam attenuator 7A, a driving system 41 for controlling the vibrations (deflection angle) of the vibration mirror 7B, a driving mechanism 42 for moving a blind blade in order to continually vary the shape of the aperture of the reticle blind 7L, especially a slit width, and a driving mechanism 43 for infinitesimally moving the lens system G2 within the projection lens system PL described above are arranged in the system according to this embodiment.

Additionally, in this embodiment, also a lens controller 44 for correcting an isotropic distortion aberration (projection magnification) by sealing a particular air chamber within the projection lens system PL from the open air, and applying a gas pressure within the sealed chamber, for example, in a range of approximately ±20 mmHg. This lens controller 44 also serves as a controlling system for the driving system 43 of the lens system G2, and controls a magnification change by switching between the driving of the lens system G2 and the pressure control of the sealed chamber within the projection lens system PL, or by using both of them.

However, if the ArF excimer laser light source with a wavelength of 193 nm is used as an illumination light, the mechanism for increasing/decreasing the pressure within the particular air chamber within the projection lens system PL may be omitted. This is because the insides of the illumination paths and the lens barrel of the lens system PL are replaced by nitrogen or helium gas.

To part of a reticle stage 8 supporting the reticle R, a movable mirror 48 for reflecting a measurement beam from a laser interferometer 46 for measuring a move position or a move amount is installed. In Fig. 1, the interferometer 46 is illustrated to be suitable for a measurement in the X direction (non-scanning direction). Actually, however, an interferometer for measuring a position in the Y direction and an interferometer for measuring the θ direction (rotation direction) are arranged, and movable mirrors corresponding to the respective interferometers are securely disposed to the reticle stage 8. Accordingly, in the explanation provided below, the measurements of the X, Y, and θ directions are assumed to be individually made by the laser interferometer 46 at the same time for the sake of convenience.

The positional information (or the speed information) of the reticle stage 8 (that is, the reticle R) measured by the interferometer 46 is transmitted to a stage controlling system 50. The stage controlling system 50 fundamentally controls a driving system (such as a linear motor, a voice coil motor, a piezo motor, etc.) 52 so that the positional information (or the speed information) output from the interferometer 46 matches an instruction value (target position or target speed).

In the meantime, a table TB for supporting and flattering the wafer W with vacuum absorption is arranged on a wafer stage 14. This table TB is infinitesimally moved in the Z direction (the optical axis direction of the projection optical system PL) and tilted relative to the X-Y plane by three actuators (piezo, voice coil, etc.) ZAC arranged on the wafer stage 14. These actuators ZAC are driven by a driving system 56, and a driving instruction to the driving system 56 is issued from a controlling system 58 of the wafer stage.

Although not shown in Fig. 1, a focus leveling sensor for detecting a deviation (focus error) or a tilt (leveling error) in the Z direction between the image plane of the projection optical system PL and the surface of the wafer W is arranged in the neighborhood of the projection optical system PL, and the controlling system 58 controls the driving system 56 in response to a focus error signal or a leveling error signal from that sensor. An example of such a focus/leveling detection system is disclosed in detail by the Japanese laid-open Publication NO. 7-201699 (NC: Okumura).

Additionally, to part of the table TB, a movable mirror 60 used to measure the coordinate position of the wafer W, which changes with the moving of the wafer stage 14 on the X-Y plane, is secured. The position of the movable mirror 60 is measured by a laser interferometer 62. Here, the movable mirror 60 is arranged to measure the movement position (or speed) of the stage 14 in the X direction. Actually, however, also the movable mirror for measuring a movement position in the Y direction is arranged, and a critical dimension measurement beam is irradiated from the laser interferometer also to the movable mirror for the Y direction in a similar manner.

Additionally, the laser interferometer 62 comprises a differential interferometer for measuring an infinitesimal rotation error (including also a yawing component), which can occur on the X-Y plane due to an X-Y move of the wafer stage 14 or an infinitesimal move of the table TB, in real time. The respectively measured positional information of the X, Y, and θ directions of the wafer W are transmitted to the wafer stage controlling system 58. This controlling system 58 outputs a driving signal to the driving system (such as three linear motors) 64 for driving the wafer stage 14 in the X and the Y directions based on the positional or speed information measured by the interferometer 62 and an instruction value.

Furthermore, a synchronous controlling system 66 monitors the states of the respective positions and speeds of the reticle R and the wafer W, which are measured by the respective interferometers 46 and 62 in real time, in order to make the control of the driving system 52, which is performed by the reticle stage controlling system 50, and the control of the driving system 64, which is performed by the wafer stage controlling system 58, reciprocally function, especially when the reticle stage 8 and the wafer stage 14 are synchronously moved at the time of scan-exposure, and manages the reciprocal relationship therebetween to be a predetermined one. The synchronous controlling system 66 is controlled by respective command and parameter types from a minicomputer 32.

In this embodiment, a image detector KES for photoelectrically detecting a test pattern image or an alignment mark image on the reticle R, which are projected through the projection optical system PL, is secured to part of the table TB. This image detector KES is attached so that its surface is as high as the surface of the wafer W.

On the surface of the image detector KES, a shading plate is formed. On the shading plate, a multi-slit or a rectangular aperture (knife-edge aperture) through which part of an image projected by the projection optical system PL passes is formed, and image luminous flux which passes through the slit or the aperture is detected as a quantity of light.

In this embodiment, the image formation performance of the projection optical system PL or the illumination characteristic of the illumination optical system can be measured by the image detector KES, and the optical elements and mechanisms of the respective types shown in Fig. 1 can be adjusted based on the measurement result. Examples of the configuration of the image detector and a measurement using the image detector are disclosed in detail by the Japanese laid-open Publications No. 9-115820 (Nikon) and No. 9-153448 (Nikon).

Additionally, in the system configuration according to this embodiment shown in Fig. 1 , an alignment optical system ALG of an off-axis type for optically detecting an alignment mark formed in each shot area on the wafer W, or a reference mark formed on the surface of the image detector KES, is arranged very much close to the projection optical system PL. This alignment optical system ALG irradiates a non-photosensitized illumination light (overall or spot illumination) to a resist layer on the wafer W through an objective lens, and photoelectrically detects a light reflected from the alignment or reference mark through the objective lens.

The photoelectrically detected mark detection signal is waveform-processed by a signal processing circuit 68 according to a predetermined algorithm, and the coordinate position (shot alignment position) of the wafer stage 14, such that the center of the mark matches the detection center (indication mark, a reference pixel on the image plane, a reception slit, a spot light, etc.) within the alignment optical system ALG, or the positional deviation amount of the wafer mark or the reference mark from the detection center is obtained in cooperation with the interferometer 62. Thus obtained information of the alignment position or the position deviation amount is transmitted to the minicomputer 32, and is used to align the position of the wafer stage 14 or to set the start position of scan-exposure for each shot area on the wafer W.

Next, the method for manufacturing the image distortion correction plate G1 as one characteristic configuration in this embodiment will be briefly explained.

As described above, the correction plate G1 is configured to be a plate on which part of the surface of a quartz or fluorite parallel plate is polished with the precision of a wavelength order, and a predetermined infinitesimal slope is formed on part of the surface, and is intended to change an image distortion on an image plane by deflecting the principal ray of local image luminous flux, which passes through the infinitesimal slope.

An example of the method for manufacturing this correction plate G1 or its operation is disclosed in detail by the Japanese laid-open publication No. 8-203805 (Nikon).

In case of scan-exposure, an image distortion which statically occurs at each of a plurality of images arranged in the move direction of the wafer W at the time of scan-exposure emerges as a dynamic image distortion which is averaged or accumulated within an effective exposure field (exposure slit width). Accordingly, a random image distortion consequently remains even if a static distortion characteristic is corrected in case of scan-exposure.

Therefore, in this embodiment, close attention is paid not to the static distortion characteristic (distortion aberration characteristic) within the effective projection area EIA at the time of scan-exposure, but to the dynamic distortion characteristic which occurs due to the accumulation (averaging) in the scanning direction of the projection area EIA, and the image distortion correction plate G1 is polished so that the dynamic distortion characteristic becomes almost "0" or the distortion characteristic becomes regular by correcting the random component included in the dynamic distortion characteristic.

For the process of the image distortion correcting plate G1, the operation for measuring an image distortion causing a dynamic distortion characteristic is required at first. There are two types of the method of the measurement operation: the offline measurement by test printing (test exposure), and the onbody measurement using the image detector KES secured onto the wafer table TB of the projection exposure apparatus shown in Fig. 1.

The method of the test exposure is intended to obtain a static image distortion at each point within a circular field or at each point within the effective projection area EIA of the projection optical system PL by statically exposing a test mark formed at an ideal lattice point on a test reticle onto a wafer W through the projection optical system PL, by conveying the exposed wafer W to a measurement device different from the projection exposure apparatus after developing the wafer W, and by measuring the coordinate position or the position deviation amount of the printed test mark.

In the meantime, the method using the image detector KES is intended to obtain a static image distortion vector by moving the wafer stage 14 in the X and the Y directions in order to scan an image with the knife-edge of the image detector KES while projecting the image of a pattern of a test mark (a line and space pattern having a cycle in the X direction, a line and space pattern having a cycle in the Y direction, a RANPASU mark or a vernier mark used to examine a resolution or an overlapping accuracy, etc.) formed at each ideal lattice point on a test reticle , and by analyzing the waveform of the photoelectric signal output from the image detector KES at that time.

After the static image distortion vector is obtained, a dynamic distortion characteristic is obtained by averaging each image distortion in the scanning direction (Y direction) within the rectangular effective projection area EIA with the use of a computer (a computer, a workstation, etc.). Thereafter, the portion of the surface corresponding to the image distortion correction plate G1 is polished in correspondence with the position in the non-scanning direction (X direction) based on the obtained dynamic distortion characteristic.

As described above, the polished image distortion correction plate G1 is relocated in the initial position within the projection optical path, that is, the position located when the distortion characteristic is measured before being polished, and the measurement operation of the distortion characteristic using a test reticle is again performed to examine the dynamic distortion characteristic.

However, the distortion component must be reduced almost to "0" by the adjustment of the tilt of the image distortion correction plate G1, the up-and-down movement and the infinitesimal tilt of the lens element G2 or the subtle change of the magnification by pressure control. Therefore, it is examined how much a random distortion component is included in the dynamic distortion characteristic remeasured after the adjustment. If the random component is within a standard value, the sequence of the manufacturing process of the image distortion correction plate G1 is terminated.

In the meantime, if the random component in the dynamic distortion characteristic is not within the standard value, the image distortion correction plate G1 is again polished based on the re-measured distortion error data depending on need.

Explained next is the optical condition of the illumination optical system of the projection exposure system, which must be considered when a distortion characteristic is measured in this embodiment. As explained earlier by referring to Fig. 1, the illumination optical system of the projection exposure apparatus of this type is normally configured as a Kohler's illumination system which images a plane light source image (actually a set of 5 to 10 thousand luminance points) formed on the exit side of the second fly-eye lens 7G at an entrance pupil or an exit pupil of the projection optical system PL. With this system, an even illuminance distribution of approximately ±1 percent is respectively obtained at the position of the blind 7L as the first irradiated plane, the position of the pattern plane of the reticle R as the second illuminated plane, and the position on the image plane (wafer plane) of the projection optical system PL as the third irradiated plane if no contrast of the interference fringes (or speckle) caused by the coherence of an excimer laser beam is assumed to exist.

However, with the recent improvement of the density and the minuteness of a semiconductor device, problems have arisen not only in the evenness of the illuminance distribution on an irradiated plane but also in the deviation from a telecentric condition of an illumination light irradiated on the irradiated plane (especially on the wafer plane), that is, a telecentric error. Note that, however, this telecentric error is construed as including also a telecentric error possessed by the projection optical system PL itself.

Especially, in recent years, the respective types of an illumination a diaphragm plate (hereinafter referred to as a spatial filter) 7H such as an annular aperture, a 4-aperture, a small circular aperture, a large circular aperture, etc. are arranged to be exchangeable on the exit side of the second fly-eye lens 7G as shown in Fig. 1, and the shape of the illumination light source plane is changed according to the pattern on the reticle R.

In this case, the telecentric correction plate 7H may be inserted in the potical path in the neighborhood of the condenser lens system shown in Fig. 1, wherein the telecentric correction plate 7H is polished with a method similar to the method for manufacturing the image distortion correction plate G1 so as to correct a telecentric error of the illumination light at each point on the irradiated plane, and wherein the telecentric error of the illumination light reaching the wafer W is measured at the each point of the irradiated plane in a state where the spatial filter 7H is not inserted in the optical path or in a state where the large circular aperture of the spatial filter 7H is inserted in the optical path. Or, in this case, an aspheric process, such that the measured telecentric error is corrected, may be performed for a particular lens element included in the condenser lens system 7K, 7Q, etc. shown in Fig. 1.

Accordingly, it becomes necessary to accurately measure the telecentric error of an illumination light on the image plane side of the projection optical system PL. For that measurement, the above described image detector KES and test reticle TR can be used as they are. To obtain the telecentric error, the X-Y coordinate position of a projection image is repeatedly measured by scanning the projection image of a line and space (L&S) pattern on the test reticle TR with the rectangular aperture of the image detector KES while changing the position of the wafer table TB in the Z direction by a predetermined amount (such as 0.5 μm) based on the detection result of a focus detection system of an oblique incident light type, so that the change in the X-Y coordinate position of one L&S pattern image according to the change of the position in the Z direction, that is, the direction and the amount of the tilt of the principal ray of the L&S pattern image to the Z axis are measured.

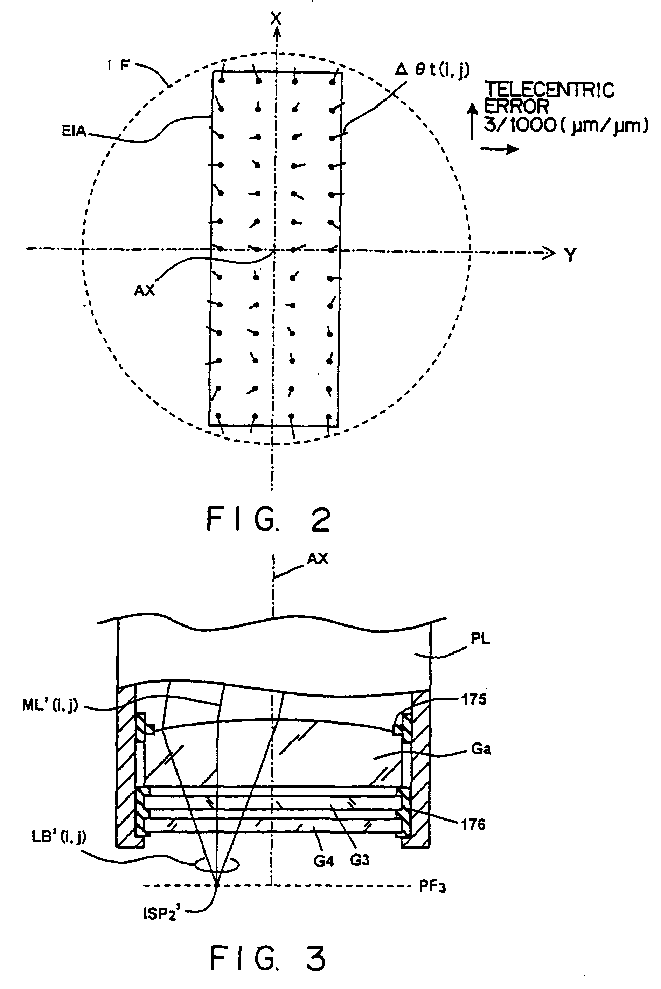

By making such a telecentric error (a tilt error of an image formation principal ray) measurement for each projection image of the L&S pattern arranged at each ideal lattice point on the test reticle TR, the telecentric error distribution within the projection image plane or the effective projection area EIA can be known, for example, as Fig. 2. Fig. 2 exemplifies the exaggerated distribution of a local telecentric error occurring within the effective area EIA. Black points in this figure represent ideal lattice points or points conforming thereto, and a segment extending from each of the black points represents a telecentric error vector (direction and magnitude) $\Delta\theta t(i,j)$.

This telecentric error vector $\Delta\theta t(i,j)$ represents how much the principal ray at a projection image point shifts in the X and the Y directions per distance of 1000 μm in the Z direction as an example. The overall tendency of the vector map shown in Fig. 2 exhibits the coexistence of a component which is similar to a distortion characteristic and can be function-approximated and a random component.

Accordingly, by measuring a telecentric error vector map like the one shown in Fig. 2, the coordinate position within the projection field IF where a telecentric error to be modified (corrected) occurs is determined, and the correction amount of the of a principal ray at the determined coordinate position is calculated, and the infinitesimal slope of a wavelength order may be formed by locally polishing the surface of the telecentric correction plate 7N (or lens element) based on the result of the calculation.

Additionally, it is desirable to simulate the polished state of the telecentric correction plate 7N by measuring the telecentric error characteristic of an illumination light with the image detector KES, to perform an actual polishing process based on the result of the simulation, and to perform the polishing process (modification polishing) again for the telecentric correction plate 7N in consideration of the result of observing and measuring the state of the resist image by using an optical or an electric microscope when test printing (scan-exposure) is performed with the processed telecentric correction plate 7N inserted.

As described above, the method for performing a polishing process based on both of the result of photoelectric detection of a spatial intensity distribution of a projection image, and a measurement result of the quality of an image which is actually etched on a resist layer by test printing can be applied also to the manufacturing of the image distortion correction plate G1 as well as the telecentric correction plate 7N, thereby maximizing the projection performance when an actual device pattern is scan-exposed onto the wafer W.

Additionally, the telecentric correction plate 7N can collectively correct a telecentric error (offset amount) which equally occurs at each point within the projection field if this plate is arranged to be tiltable in a direction arbitrary to the plane vertical to the optical axis AX of the illumination system, similar to the image distortion correction plate G1 described earlier.

In the meantime, with the measurement of an L&S pattern projection image, which uses the image detector KES, an image plane astigmatism or coma aberration occurring at each point within the projection field IF or within the rectangular projection area EIA, an image plane curvature, etc. can be measured. Accordingly, also the astigmatism/coma correction plate G3 to be provided at the bottom of the projection optical system PL, which is shown in Fig. 1, is polished so that the dynamic aberration characteristic is reduced to "0" by averaging the aberration mount at the time of scan-exposure, or a random component in the dynamic aberration characteristic is corrected, or the aberration amount is reduced to "0" in a static state based on the astigmatism/coma aberration amount measured at each point within the projection field IF or the rectangular projection area EIA, similar to the image distortion correction plate G1, the astigmatism/coma correction plate G3 is inserted in the bottom of the projection optical system PL after being polished.

Furthermore, although omitted in Fig. 1, the image plane curvature correction plate (quartz plate) G4 having the plane shape for correcting the curvature of a projection image plane is attached to the bottom of the projection optical system PL in parallel with the astigmatism/coma correction plate G3. Fig. 3 is a partial sectional view showing the bottom of the projection optical system PL, and the state where a lens element Ga closest to the projection image plane PF3 is secured within the lens barrel of the projection optical system PL through a ring-shaped metal support 175, and the state where the astigmatism/coma correction plate G3 and the image plane curvature correction plate G4 are secured between the lens element Ga and the image plane PF3 within the lens the lens barrel with a ring-shaped metal support 176.

With the scan-exposure method, since a static image plane curvature characteristic is added and averaged in a scanning direction, there is a possibility that a non-linear (random) image plane curvature error, which cannot be completely modified only by correcting an image tilt and an image plane curvature with the replacement of a lens element like a static exposure method, remains.

Accordingly, in this embodiment, an image plane curvature correction plate is processed to accurately correct a non-linear (random) image plane curvature error in consideration of a dynamic image plane curvature characteristic.

Here, it is assumed that the image plane PF3 is a best focus plane which is optically conjugate to the pattern plane of the reticle R, and a primary ray ML'(i,j) of the image formation luminous flux LB'(i,j), which converges at an image point ISP2', is parallel to the optical axis AX between the lens element Ga and the image plane PF3. At this time, the numerical aperture NAw of the image formation luminous flux LB'(i,j) is larger by an inverse number of the projection magnification (1/4, 1/5, etc.) in comparison with the numerical aperture NAr on the reticle side, and is approximately 0.5 to 0.7.

Therefore, the spread area of the image luminous flux LB'(ij) when passing through the astigmatism/coma correction plate G3 and the image plane curvature correction plate G4 becomes much larger than the image distortion correction plate G1 on the reticle side. Accordingly, the overlapping between the image formation light which generates another image point positioned in the neighborhood of the image point ISP2' and the image formation luminous flux LB'(i,j) on the astigmatism/coma correction plate G3 cannot be avoided.

However, the polishing of the surface of the astigmatism/coma correction plate G3 is not required to be taken into account for the entire surface of the astigmatism/coma correction plate G3, in consideration of the fact that also the aberration characteristic in the width direction (scanning direction) within the rectangular projection area EIA is averaged by scan-exposure, and may be performed for a local area in consideration of the averaging at the time of scan-exposure. Therefore, the stitching of a polished surface when polishing the astigmatism/coma correction plate G3 can be relatively performed with ease.

In the meantime, the image plane curvature is determined by measuring the best focus position (Z position) of each image of L&S patterns formed on the test reticle TR, which is projected under a certain illumination condition, with the off-line method by test printing and the image detector KES, and by obtaining an approximate plane (a curved surface) on which the measured best focus position at each point is approximated with a least square, etc.

In this case, the detection of a projected image with the image detector KES is performed by changing the Z position of the table TB while measuring the position of the height position of the surface of the shading plate of the image detector KES with a focus detection system such as an oblique incident light method, etc., and the Z position of the table TB such that also the contrast (the peak value of a differential waveform, a level of a bottom value) of the L&S pattern projection image becomes the highest is measured as the best focus position.

If the flatness of the approximate plane of the projection image plane thus determined is not within an allowable range at least in the rectangular projection area EIA at the time of scan-exposure, the polishing process such that an image plane curvature is modified by taking out the image plane curvature correction plate G4 from the projection optical system PL is performed. In this case, the image plane curvature correction plate G4 is normally manufactured to correct the tendency of the entire image plane curvature within the projection field by entirely polishing its one side with a positive curvature, and the other with almost a same negative curvature. As a result, the projection image plane by a projection optical system can be made entirely and locally even, whereby a good effect of significantly improving a DOF (Depth Of Focus) can be promised.

If there is a portion where the image plane curvature is locally large within the projection field (with the rectangular projection area EIA), it is also possible to correct that portion by locally performing additional polishing. Additionally, it is desirable to measure a profile of an actual resist image printed by test exposure and to consider also the result of that measurement not only depending on a photoelectric measurement result of a projection image by, which is obtained by the image detector KES, also when the above described astigmatism/coma correction plate G3, the image plane curvature correction plate G4 are manufactured.

Next, other illumination condition which must be considered when the above described distortion characteristic, astigmatism/coma aberration, image plane curvature, etc. are measured will be explained. As described earlier, an even illuminance distribution of approximately ±1 percent can be obtained on an irradiated plane of the position of the blind 7L, the position of the pattern plane on the reticle R (test reticle TR), the position of the image plane (wafer plane) of the projection optical system PL, etc. by the operations of the first fly-eye lens 7C and the second fly-eye lens 7G, which are shown in Fig. 1.

However, it is also proved that the irradiation state of an illumination light has not only a problem in the evenness of an illuminance distribution on an irradiated plane, but also a problem in the local degradation of an overall image formation performance including a resolution, a distortion error, respective aberration types, etc. due to the phenomenon that the numerical aperture (NA) of the illumination light partially differs according to the position on the irradiated plane, that is, an occurrence of an NA difference (unevenness within an illumination angle) according to a image height which is the distance from the optical axis AX. This phenomenon is caused not only by a σ value change depending on the image height position of the illumination system, but also by the respective aberration types of the illumination optical system from the second fly-eye lens 7G to the reticle R shown in Fig. 1, an arrangement error when a plurality of optical components configuring the illumination optical system are assembled and manufactured, or an angle characteristic of a thin film for preventing a reflection, which is coated on the respective optical components, etc.

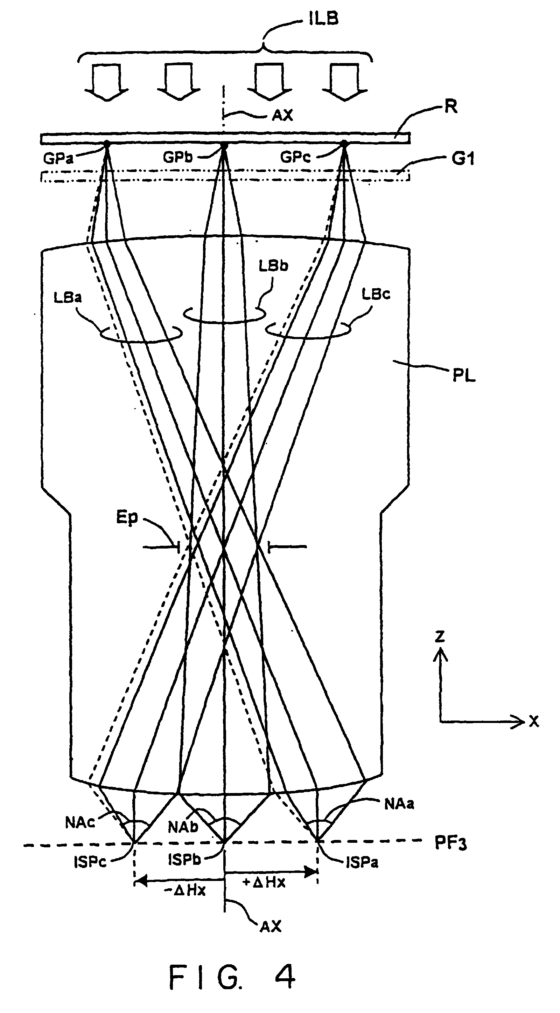

Additionally, such an NA difference of the illumination light according to the image height is a phenomenon which can possibly occur due to an aberration of the projection optical system PL by itself. After all, as exaggeratedly shown in Fig. 4, for example, numerical apertures NAa, NAb, and NAc of image formation luminous flux LBa, LBb, and LBc for forming respective three image points ISPa, ISPb, and ISPc on the projection image plane PF3 differ depending on the image height position ±ΔHx.

Fig. 4 shows the state where an object point (ideal lattice point) GPb at a position on the optical axis AX on the reticle R, an object point GPc apart from the object point GPb by a distance M·ΔHx in a positive direction (axis in a non-scanning direction) along the X axis, and an object point GPa apart from the object point GPb by the distance M·ΔHx in a negative direction of the X axis are respectively imaged and projected as image points ISPa, ISPb, and ISPc through a bilaterally telecentric projection optical system PL at a reduction magnification 1/M (M is on the order of 2 to 10).

At this time, the reticle R is irradiated with an almost even intensity distribution by an illumination light ILB which is adjusted to be a predetermined numerical aperture and a predetermined σ value, and the image formation luminous flux LBa, LBb, and LBc, which proceed to the image plane PF3 side without being shaded by the pupil (diaphragm aperture) Ep of the projection optical system, among the lights entering from the respective object points the projection optical system PL via the image distortion correction plate G1, contribute to the image formation of the respective image points.

Furthermore, in Fig. 4, partial luminous flux indicated by broken lines at the left side of the respective image luminous flux LBa and LBc represent portions which are lost as or attenuated as unevenness within an illumination angle from the original aperture state. If an NA difference according to the image height position as described above, a gravity center line, which is determined by the center of gravity of light quantity on each of the sectional planes of the image formation luminous flux LBa and LBc, becomes the one tilting from the principal ray on the image plane PF3, although each of the principal rays of the image formation luminous flux LBa at the image height+ΔHx, and the image formation luminous flux at the image height-ΔHx passes through the central point (optical axis AX) of the pupil Ep.

Considered will be the case where an L&S pattern almost at a resolution limit, which is positioned, for example, in the center of the illumination area on the reticle R, that is, in the neighborhood of the optical axis AX of the projection optical system PL, and an L&S pattern almost at a resolution limit, which is positioned at the periphery of the illumination area apart from the optical axis AX, are projected and exposed in the state where there is such an NA difference according to the image height of the illumination light.

In this case, even if the intensity distributions of the illumination light irradiating the respective L&S patterns at the two positions are identical, an effective NA of the illumination light for the L&S pattern in the neighborhood of the optical axis AX is larger (smaller depending on a case) than the illumination light for the L&S pattern apart from the optical axis AX. Therefore, a difference exists between the resolutions of the L&S patterns in the neighborhood and the periphery of the optical axis, which are finally transferred onto the wafer W, which poses a problem such that the contrast or the line width of a transferred image may differ depending on the position on the image plane although the L&S patterns have the same line width and pitch.

Additionally, the NA difference of the illumination light causes a problem such that the line widths or duties of the projection images of two L&S patterns may be infinitesimally changed according to a pitch direction, when the two L&S patterns of a same design with different pitch directions are closely arranged on the reticle.

Although there is no effective NA difference between the center of an illumination area and its periphery, there may arise a problem such that the whole of the illumination luminous flux irradiated on the reticle R (or the wafer W) slightly tilts not at an angle symmetrical with respect to the optical axis AX, but in a certain direction. However, its adjustment can be made by infinitesimally moving the positions of the second fly-eye lens 7G and the other optical elements within the illumination optical system in the X, Y, Z, or θ direction in that case.

The above described NA difference according to the image height of an illumination light naturally becomes a problem also when the above described distortion characteristic is measured, when the telecentric error map shown in Fig. 2 is measured, or when the astigmatism/coma aberration and the image plane curvature are measured, and an error is included in measured static image distortion, telecentric error, etc.

Therefore, it is desirable that the NA difference according to the image height of an illumination light irradiated on the reticle R is adjusted when a distortion is measured at the time of manufacturing the image distortion correction plate G1, when a telecentric error is measured, when an astigmatism/coma aberration is measured, or when image plane curvature is measured, to say nothing of when a wafer is exposed on a device manufacturing line. Arranged for such an adjustment is the plate for correcting an illumination NA difference (hereinafter referred to as an illumination NA correction plate) 7F, which is positioned on the incidence plane side of the second fly-eye lens 7G shown in Fig. 1.

In the meantime, the image detector KES explained earlier is intended to detect a quantity of light within a rectangular aperture on a projection image plane, and cannot detect the quantity by making a distinction between the illuminance of an illumination light on a projection image plane and the NA difference according to the image height of the illumination light. Meanwhile, since the resist layer on the wafer W is photosensitized to the NA difference according to the image height of an illumination light and to an illuminance change, a definite distinction emerges in the image formation characteristic (resist profile) of the pattern image projected onto the resist layer.

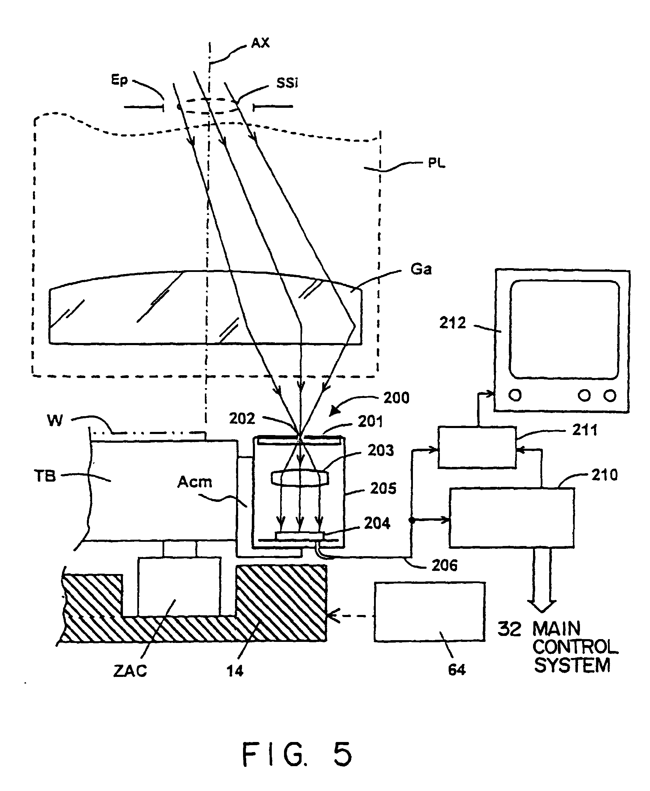

Accordingly, in this embodiment, an illumination NA measurement sensor 200, which can automatically measure the NA difference according to the image height of an illumination light at arbitrary timing while the apparatus is running, is arranged, for example, to be attachable/detachable onto/from the wafer table TB in Fig. 1 via a metal fixture Acm as shown in Fig. 5. Fig. 5 is an enlarged view showing the partial structure of the table TB to which the illumination NA measurement sensor 200 is attached, and the bottom of the projection optical system PL. On the top of the sensor 200, a shading plate 201 on which a shading layer of chrome, etc. is formed on the entire surface of a quartz plate is formed is arranged, and a pin hole 202 having a diameter which is determined based on a wavelength λ of an illumination light, the numerical aperture NAw on the image side of the projection optical system PL, etc. is arranged in a portion of the shading layer.

Under the pin hole 202 of the shading plate 201, a lens element 203 for transforming an illumination light passing through the pin hole 202 into parallel luminous flux, that is, a Fourier transform lens is arranged. On the Fourier transform plane implemented by the lens element 203, a CCD 204 as a two-dimensional imaging element is arranged. These shading plate 201, lens element 203, and CCD 204 are collectively included in a case 205 of the sensor 200. The image signal from the CCD 204 is transmitted to a display 212 via a signal cable 206, an image processing circuit 210, and a video signal mixer circuit 211. On the display 212, a light source image SSi which is formed in the pupil Ep is displayed. Note that the image processing circuit 210 comprises the software for detecting the optical intensity distribution of the light source image SSi in correspondence with the arrangement of the lens elements of the second fly-eye lens 7G, and for analyzing a portion which is especially uneven in the intensity distribution, and has a capability for transmitting the result of the analysis to the main control system (minicomputer) 32 in Fig. 1.

In the above described configuration of the sensor 200, the surface of the shading plate 201 of the sensor 200 is located at the Z position matching the projection image plane PF3 of the projection optical system PL, or the Z position accompanying a predetermined offset from the projection image plane PF 3 by the focus detection system and the actuator ZAC in a predetermined leveling state, when the NA difference of an illumination light is measured. Additionally, the XY stage 14 is driven by the driving system 64 so that the pin hole 202 is located at arbitrary X, Y position within the projection field IF or the rectangular projection area EIA of the projection optical system PL.

When a measurement is made, a reticle on which no patter is drawn is mounted on the reticle stage 8, the reticle is evenly illuminated by an illumination light ILB, and the pin hole 202 is located at the image height position to be measured within the projection field If or the rectangular projection area EIA. Because the illumination light ILB is a pulse light at that time, the illumination light which passes through the pin hole 202 is accumulated and photoelectrically detected while the illumination light ILB is irradiated with a predetermined number of pulses if the CCD 204 is arranged as a charge storage type.

Since the imaging plane of the CCD 204 is the Fourier transform plane, the CCD 204 comes to image the intensity distribution of the light source image SSi formed in the pupil Ep of the projection optical system PL. However, the light source image SSi formed in the pupil EP is similar to the shape of the portion which has passed through the aperture of the spatial filter 7H among innumerable luminance point set planes formed on the exit plane side of the second fly-eye lens 7G in Fig. 1.

Since this embodiment assumes the apparatus for performing scan-exposure in a width direction (Y direction) of the rectangular projection area EIA, also an influence by the illumination NA difference of the quality of a pattern image transferred onto the wafer W is an average of the illumination NA difference in the size of the width direction of the projection area EIA. Accordingly, it is desirable to obtain a dynamic illumination NA difference by partitioning the projection area EIA into a plurality of areas at predetermined intervals in the non-scanning direction (X direction), and by averaging the static illumination NA difference in the scanning direction for each of the partitioned areas, in a similar manner as in the case of the distortion measurement.

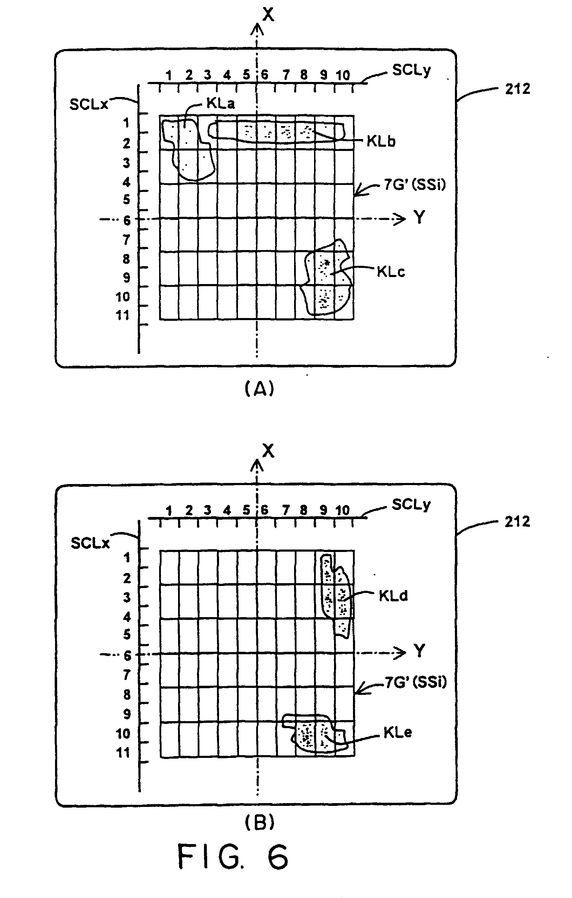

Therefore, the measurement of the static illumination NA difference will be explained by referring to Figs. 6(A) and 6(B). Figs. 6(A) and 6(B) illustratively show the examples of the light source image SSi, which are respectively displayed on the display 212 when the pin hole 202 is located at different positions within the projection area EIA. On the screen of the display 212, a cursor line representing an array 7G' (light source image SSi) of the lens element on the exit side of the second fly-eye lens 7G, and scales SCLx and SCLy which represent the positions in the X and the Y directions are displayed at the same time.

In Figs. 6(A) and 6(B), the array 7G' on the exit plane side of the second fly-eye lens 7G is modified to be almost a square as a whole, and the sectional shape of each lens element is a rectangle which is almost similar to the projection area EIA. That is, since the incidence plane side of each lens element is conjugate to the irradiated plane (blind plane, reticle plane, or projection image plane), the size of the sectional shape in the scanning direction (Y direction) is smaller than that in the non-scanning direction (X direction) in order to efficiently irradiate the projection area EIA on the irradiated plane.

In case of Fig. 6(A), each of the intensities of an area KLa at the upper left corner, an area KLb in the top row, and an area KLc at the lower right corner within the array 7G' is lower than its peripheral intensity and a telerable value. Meanwhile, Fig. 6(B) shows an example where each of the intensities of an area KLd at the upper right corner and an area KLe at the lower right corner within the array 7G' is lower than its peripheral intensity and a telerable value.

As described above, since the intensity distribution of the light source image SSi formed in the pupil Ep of the projection optical system PL varies according to the position within the projection field of the pin hole 202, that is, the image height, the quality of a projected image of the pattern formed on the reticle R (or TR) may be sometimes deteriorated. For example, if the center of gravity of the entire distribution of the light source image SSi (array 7G') is decentered from the coordinate origin (optical axis AX)in a lower left direction as shown in Fig 6(A), the image formation luminous flux of the pattern projected at the image height position becomes the one deteriorated from the telecentric state. If a comparison is made between Figs. 6(A) and 6(B), an NA of illumination luminous flux on the projection image plane PF3 is smaller as a whole in Fig. 6(A).

Note that the shape of the light source image SSi when the wafer W is actually scan-exposed is set by the aperture shape of the spatial filter 7H which is arranged on the exit side of the second fly-eye lens 7G. Therefore, the shape of the light source image SSi becomes the aperture shape (circular, annular, 4-aperture, etc.) in the square array 7G' shown in Fig. 6(A) or 6(B), which is restricted by the spatial filter 7H.

To average such an illumination NA difference according to the image height within the projection field, a plurality of measurement points in a matrix state are set within the rectangular projection area EIA, the image signal from the CCD 204 is observed on the display 212 each time the pin hole 202 is located at each of the measurement points, and an uneven area within the intensity distribution of the light source image SSi (array 7G') is analyzed by the image processing circuit 210, and the static illumination NA characteristic (the vector representing the directionality of an NA and its degree) at each of the measurement points is sequentially stored based on the result of the analysis.

Thereafter, a dynamic illumination NA characteristic is calculated by averaging the illumination NA characteristic at several measurement points arranged in the scanning direction among the static illumination NA characteristic at the respective measurement points. This dynamic illumination NA characteristic is obtained at predetermined intervals in the non-scanning direction of the rectangular projection area EIA, and the illumination NA difference according to the image height is obtained particularly in the non-scanning direction by making a comparison between the dynamic illumination NA characteristics.

Then, the illumination NA correction plate 7F which is arranged on the incidence plane side of the second fly-eye lens 7G in Fig. 1 is processed based on the dynamic illumination NA characteristic thus obtained, and a correction is made to reduce the difference between the dynamic illumination NAs in the non-scanning direction almost to "0". Since the rectangular projection area EIA is set along the diameter extending in the non-scanning direction within the circular projection field IF of the projection optical system PL, the dynamic illumination NA is the one according to the image height from the optical axis AX.

Accordingly, to correct the dynamic illumination NA difference in the non-scanning direction, the illumination NA correction plate 7F may be manufactured to endow the illumination σ value at each image height in the non-scanning direction with an offset. As a method for changing the illumination σ value depending on the image height, for example, a beam attenuating part for changing the size or the intensity of the illumination luminous flux entering each lens element or for decentering the intensity distribution for each lens element (rod lens) in the periphery on the incidence plane side of the second fly-eye lens 7G may be locally formed on a transparent (quarts) plate.

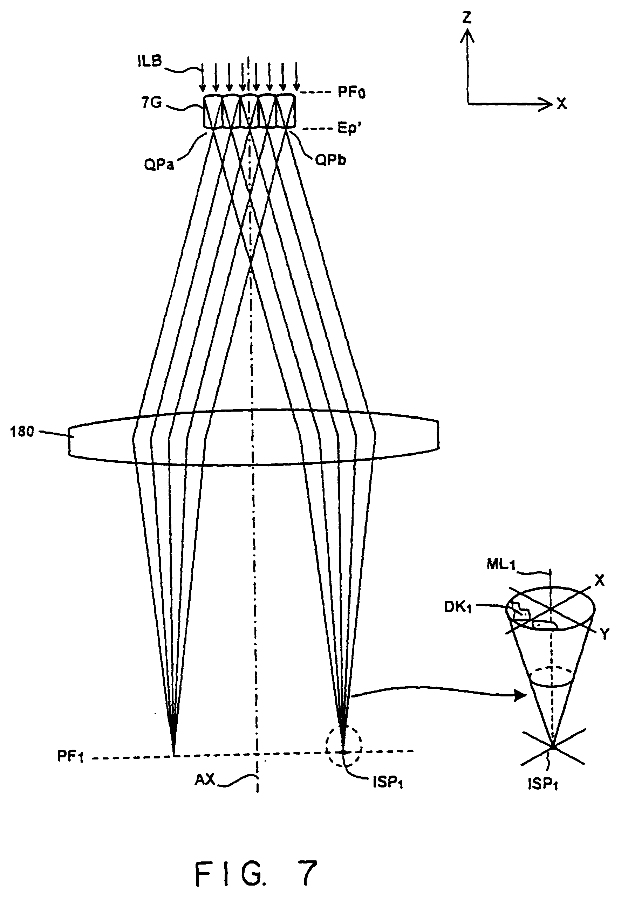

Therefore, the state of the illumination light on the irradiated plan will be briefly explained by referring to Fig. 7. Fig. 7 illustratively shows the system from the second fly-eye lens 7G to the irradiated plane PF1, which is shown in Fig. 1. A collective lens system 180 represents a synthetic system of the mirror 7J, the collective lenses 7K and 7M, the mirror 7P, and the condenser lens system 7Q, which are shown in Fig. 1. Accordingly, the irradiated plane PF1 is assumed to be the pattern plane of the reticle R, which is the second irradiated plane, for ease of explanation. However, the illumination NA difference to be actually evaluated is obtained by the projection image plane PF3 on the wafer W (or the shading plate 201 of the measurement sensor 200) side, which is the third irradiated plane including the projection optical system PL.

In Fig. 7, the second fly-eye lens 7G is a bundle of a plurality of square-pillar-shaped rod lenses, and the illumination luminous flux ILB incident on the incidence plane PF0 which is conjugate to the irradiated plane PF1 is split by each of the rod lenses and collected as a plurality of point light source images (collective points) on the exit plane Ep' side. Here, the light source images formed on the exit plane Ep' side of the rod lenses apart from the optical axis AX within the second fly-eye lens 7G are respectively assumed to be QPa and QPb.

However, since the first fly-eye lens 7C is arranged in this embodiment as explained earlier by referring to Fig. 1, the light source image formed on the exit plane Ep' side of one rod lens of the second fly-eye lens is an aggregate of the plurality of point light source images formed on the exit side of the first fly-eye lens 7C. Viewing from the irradiated plane PF1, the exit plane Ep' of the second fly-eye lens 7G is a Fourier transform plane (pupil plane), and the split light which diverges and proceeds from each of the rod lenses of the second fly-eye lens 7G is transformed into almost parallel luminous flux, and integrated on the irradiated plane PF1. In this way, the intensity distribution of the illumination light on the irradiated plane PF1 is made even.

However, observing the state of the illumination luminous flux irradiated at a peripheral irradiated point ISP1 apart from the optical axis AX on the irradiated plane PF1 in the non-scanning direction (X direction), the numerical aperture of the illumination luminous flux converged at the point ISP1 becomes smaller relatively in the X direction due to an intensity-attenuated portion DK1 within the luminous flux, as shown in the perspective view in the lower left of Fig. 7. Notice that ML1 represents a principal ray which passes through the central point of the pupil of the projection optical system PL and reaches the irradiated point ISP1 in this figure.

As described above, the illumination luminous flux including the attenuated (or intensified) portion like the portion DK1 can possibly occur if the intensity of the light source image QPa formed by the rod lens positioned at the left end of the second fly-eye lens 7 is extremely low (or extremely high), or if the intensity of the light source image QPb formed by the rod lens positioned at the right end of the second fly-eye lens 7G is extremely high (or extremely low).

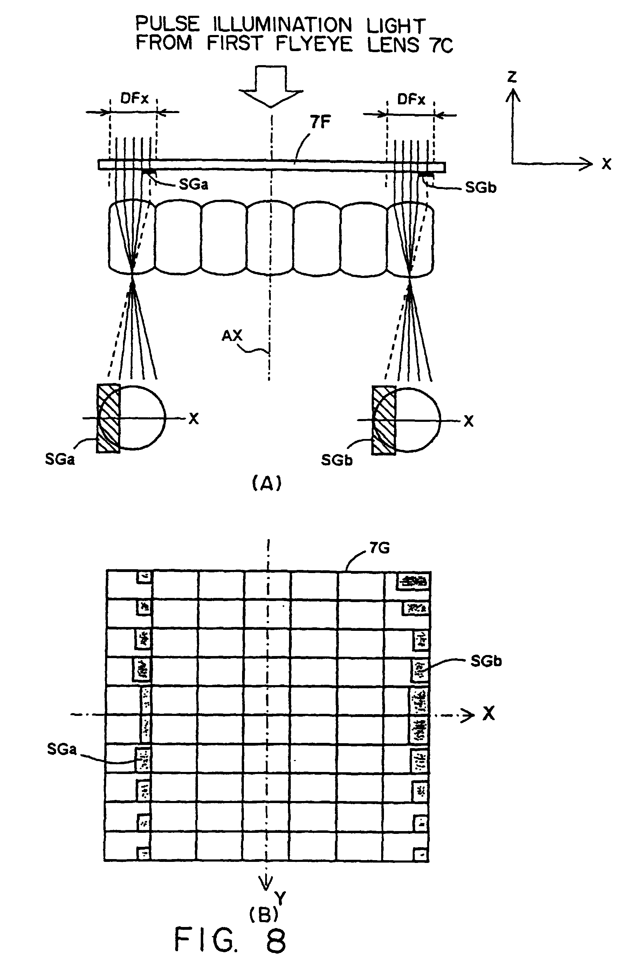

Accordingly, for example, as shown in Fig. 8(A), a thin film filter unit SGa or SGb through which the illumination luminous flux having a width DFx, which enters the rod lens at the left or right end of the second fly-eye lens 7G, is entirely or partially beam-attenuated is formed on the illumination NA correction plate 7F as a shading unit. Fig. 8(A) is a schematic showing the positional relationship between the second fly-eye lens 7G and the illumination NA correction plate 7F, which is enlarged on the X-Z plane, while Fig. 8(B) is a schematic showing the positional relationship in terms of a plane between filter units SGa and SGb formed on the illumination NA correction plate 7F, and a rod lens (a rectangular section) array of the second fly-eye lens 7G.

As shown in Fig. 8(B), the section of each of the rod lenses of the second fly-eye lens 7G is a rectangle extending in the non-scanning direction (X direction), and the filter units SGa and SGb are individually arranged for each of the rod lenses existing in sequence in the Y direction at both ends of each rod lens array in the X direction. Since the dynamic illumination NA difference, especially, in the non-scanning direction is corrected in this embodiment, the filter units SGa and SGb are set by paying close attention to both ends of the sequence of rod lenses arranged mainly in the X direction also for the rod lens arrays of the second fly-eye lens 7G.

Accordingly, only either of the filter units SGa and SGb may be arranged, and the shape of the filter unit SGa or SGb may be made identical for the rod lenses staying in the Y direction. Here, however, the shapes and the locations of the filter units SGa and SGb are set to be different little by little according to the positions of the rod lenses arranged in the Y direction, and the dynamic illumination NA difference becomes small not only in the non-scanning direction but also in the scanning direction (Y direction).

Also when the illumination NA correction plate 7F is made as described above, the dynamic illumination NA characteristic is measured with the measurement sensor 200 of Fig. 5 in a state where a completely transparent plate (quartz) which becomes a preform of the illumination NA correction plate 7F is arranged on the incidence plane side of the second fly-eye lens 7G as shown in Fig. 1, and the reticle R is exchanged for a reticle on which no pattern is drawn, in a similar manner as in the above described manufacturing of the image distortion correction plate G1. Then, the filter units SGa and SGb which become beam-attenuating parts, etc. may be formed on the transparent plate (or its equivalence) which is removed from an exposure apparatus based on the result of the measurement.

As a matter of course, it is desirable to examine whether or not a correction of a dynamic illumination NA difference according to an image height is satisfactorily made by re-measuring the dynamic illumination NA characteristic with the measurement sensor 200 of Fig. 5 after a manufactured illumination NA correction plate 7F is installed in a predetermined position within the illumination optical path.

Additionally, it goes without saying that the above described manufacturing of the illumination NA correction plate 7F and illumination NA correction using this plate must be performed prior to the various measurement operations using the test reticle TR when the image distortion correction plate G3, the astigmatism/coma aberration correction plate G3, and the image plane curvature correction plate G4 are manufactured.

Meanwhile, as shown in Fig. 1, the spatial filter 7H is arranged to be switchable on the exit side of the second fly-eye lens 7G in order to change the shape or the size of the light source image SSi formed in the pupil Ep of the projection optical system PL. Therefore, if the aperture of the spatial filter 7H is switched from a normal circular aperture to an annular aperture, or from the annular aperture to 4-aperture, the optical characteristic of illumination luminous flux which irradiates the reticle R or the test reticle TR may differ, so that also an influence on the projection optical system PL may differ.

Accordingly, it is desirable that each of the above described image distortion correction plate G1, astigmatism/coma aberration correction plate G3, image plane curvature correction plate G4, illumination NA correction plate 7F is configured to be exchangeable for an optimum plate according to the shape of the aperture of the spatial filter 7H in accordance with the switching of the spatial filter 7H.

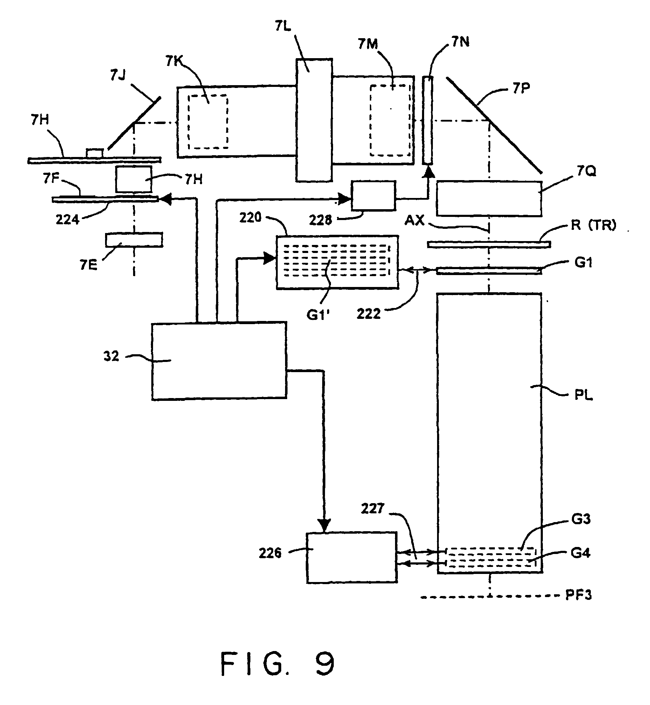

Fig. 9 shows the outline of the configuration of a projection exposure apparatus where the image distortion correction plate G1, the astigmatism/coma aberration correction plate G3, the image plane curvature correction plate G4, and the illumination NA correction plate 7F are respectively made exchangeable, and the fundamental arrangement of the respective optical components from the collective lens 7E within the illumination optical system to the projection image plane PF3 of the projection optical system PL is the same as that in the configuration of Fig. 1. In Fig. 9, the image distortion correction plate G1 is arranged to be exchangeable for a plurality of image distortion correction plates G1' which are polished beforehand according to the shape or the size of the aperture of the spatial filter 7H and are in stock in a library 220, and its exchange operations are performed by an automatic exchange mechanism 222 which operates in response to the command from the main control system 32.

Additionally, on a switch mechanism 224 such as a turret, a linear slider, etc., a plurality of illumination NA correction plates 7F can be mounted, and each of the correction plates 7F is pre-manufactured so that a dynamic illumination NA difference becomes a minimum according to the shape or the size of the aperture of the spatial filter 7H. Which illumination NA correction plate to select is determined in correspondence with the spatial filter 7H selected in response to the command from the main control system 32.

Also for the astigmatism/coma correction plate G3 and the image plane curvature correction plate G4, a plurality of plates pre-manufactured in correspondence with the switching of the spatial filter 7H are in stock in a library 226, and suitable correction plates G3 and G4 among them are selected by an automatic exchange mechanism 227 in response to the command from the main control system 32, and inserted in the bottom of the projection optical system PL.

Also for the telecentric correction plate 7N, an automatic exchange mechanism 228 for exchanging for a telecentric correction plate which is polished beforehand according to an illumination condition (spatial filter 7H) in response to the command from the main control system 32 is arranged. However, only if an average telecentric error in the whole of illumination luminous flux is equally corrected, the automatic exchange mechanism 228 may be configured merely by an actuator which adjusts a tilt of the telecentric correction plate 7N to be two-dimensional.

With the above described configuration, the respective fluctuations of the optical characteristic of illumination luminous flux and the image formation characteristic of the projection optical system PL, which occur with an illumination condition change, can be optimally corrected in response to the command from the main control system 32, and an image of the pattern formed on the reticle R can be projected and transferred onto the wafer W in a state where few aberrations (such as a distortion error including an isotropic magnification error, an image plane curvature error, an astigmatism/coma error, a telecentric error, etc.) exist in all cases.

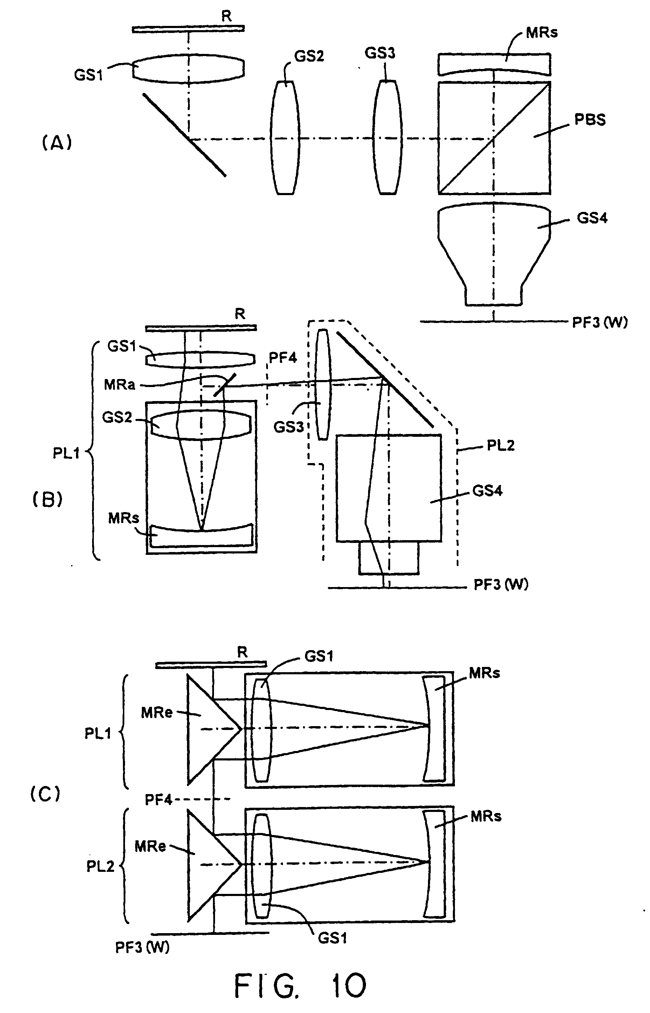

The projection optical system PL exemplified in the above described embodiments is assumed to be a reduction projection lens configured only by a dioptric element (lens) which uses quartz or fluorite as an optical glass material. However, the present invention can be applied also to other types of a projection optical system in exactly the same manner. Accordingly the other types of a projection optical system will be briefly explained by referring to Fig. 10.

Fig. 10(A) is a reduction projection optical system where dioptric elements (lens systems) GS1 through GS4, a concave mirror MRs, and a beam splitter PBS are combined. The characteristic of this system is a paint that the image luminous flux from the reticle R is reflected by the concave mirror MRs via the large beam splitter PBS, and again returned to the beam splitter PBS, and imaged on the projection image plane PF3 (wafer W) with a reduction ratio earned at the dioptric lens system GS4. Its details are disclosed by the Japanese laid-open Publication No. 3-282527 (NC).

Fig. 10(B) is a reduction projection optical system where dioptric elements (lens systems) GS1 through GS4, a small mirror MRa, and a concave mirror MRs are combined. The characteristic of this system is a point that the image luminous flux from the reticle R is imaged on the projection image plane PF3 (wafer W) through a first image formation system PL1 which is almost an equimultiple and composed of lens systems GS1 and GS2 and a concave mirror MRs, and a second image formation system PL2 which is composed of lens systems GS3 and GS4 and has almost a desired reduction ratio. Its details are disclosed by the Japanese laid-open Publication No. 8-304705 (NC: Takahashi).

Fig. 10(C) is an equimultiple projection optical system where a dioptric element (lens system) GS1 and a concave mirror MRs are combined. The characteristic of this system is a point that the image luminous flux from the reticle R is imaged on the projection image plane PF3 (wafer W) as an equimultiple orthoscopic image through first and second Dyson image formation systems PL1 and PL2, which are respectively configured by a prism reflection mirror MRe, the lens system GS1, and the concave mirror MRs. Its details are disclosed by the Japanese laid-open Publication No. 7-57986 (NC: Tanaka).

Also to the exposure apparatus comprising each of the projection optical systems shown in Figs. 10(A), 10(B), and 10(C), the above described image distortion correction plate G1, astigmatism/coma correction plate G3, and image plane curvature correction plate G4 can be attached in a similar manner. Since an intermediate image formation plane PF4 which is almost an equimultiple of a pattern within an illumination area on the reticle R is formed especially in the projection optical system of Figs. 10(B) and 10(C), at least one of the image distortion correction plate G1, the astigmatism/coma correction plate G3, and the image plane curvature correction plate G4 can be arranged in the neighborhood of the intermediate image formation plane PF4.

Additionally, the projection optical systems shown in Figs. 10(A), 10(B), and 10(C) are systems which can be sufficiently applied to an ultraviolet light having a central wavelength of 200 nm or less such as an ArF excimer laser beam, etc. by selecting an optical glass material, a surface-coated material, etc. Even when such a projection optical system is used, a significant effect such that a distortion of a pattern image which is finally transferred onto a photosensitized substrate, an absolute projection position error, or a local overlapping error can be suppressed to one-tenth (approximately several tens of nms) or less of the minimum line width of the pattern image to be transferred by carrying out the sequence of: (1) the measurement of dynamic optical characteristics (a distortion, an astigmatism/coma aberration, an illumination NA difference, etc.) under a set illumination condition; (2) the process of each correction plate type based on the result of the above described measurement; and (3) the mounting and the adjustment (including re-measurement) of each manufactured correction plate type, can be obtained.

In the meantime, the projection optical systems shown in Figs. 1 and 10(A) among the above described projection optical systems shown in Figs. 1 and 10 possess a circular projection field, while the projection optical systems shown in Figs. 10(B) and 10(C) possess almost a semicircle projection field. An effective projection area EIA which is restricted to a rectangular slit shape within a projection field is assumed to be used for scan-exposure whichever projection optical system is used. However, a slit projection area in an arc shape may be set depending on a case.

In such a case, the shape of the intensity distribution of the illumination light which illuminates the reticle R (TR) may be merely modified to be an arc-shaped slit. However, considering that the illumination light is a pulse light, it is not advantageous to make the width of the scanning direction of the arc-shaped slit as thin as disclosed by pp. 424-433 in Vol. 1088 of the above described SPIE, which is cited earlier in the explanation of the conventional technique, and some width is required.

Assume that a width Dap of an arc-shaped slit in the scanning direction on a wafer is 1mm, the number Nm (integer) of pulse lights to be emitted while the wafer is moving by that width during the scanning is 20 pulses, and the maximum frequency fp of the pulse oscillation of an illumination light is 1000Hz (conforming to the standard of a laser light source). The moving speed Vws of the wafer while one area on the wafer is being scan-exposed becomes 50mm/sec based on the relationship Vws·Dap/(Nm/fp), which proves that a throughput is improved with the widening of the slit width Dap.

Accordingly, even if an illumination light is set to have an arc-shaped slit, a width of approximately 3 to 8 millimeters, which is wider than a conventional method, must be adopted on a wafer. However, it is desirable not to make the inside arc of the illumination light having the arc-shaped slit and its outside arc concentric, but to form the slit into a crescent shape such that the width of scan-exposure of the arc-shaped slit is the same at any position in the non-scanning direction of the arc-shaped slit.

The way of thinking of the respective optical aberration corrections by the image distortion correction plate G1, the astigmatism/coma correction plate G3, the image plane curvature correction plate G4, the telecentric correction plate 7N, and the illumination NA correction plate 7F, which is explained in the embodiments of the present invention, is applicable also to an X-ray exposure apparatus which comprises a reduction projection system configured only by catoptric elements (a concave mirror, convex mirror, a toroidal reflection mirror, a plane mirror, etc.) in addition to the projection optical system configured by a catadioptric system (a system where a dioptric element and a catoptric element are combined) shown in Fig. 10.

Because there is no optical material having a satisfactory dioptric operation for an ultra-high-frequency illumination light, corrections of the distortion characteristic, the astigmatism/coma aberration characteristic, the telecentric characteristic, etc. can be implemented by locally and infinitesimally transforming the plane shape of the reflection surface of a catoptric element in a dedicated manner. As the method for performing an infinitesimal transformation, for example, the method for polishing a reflection layer, which is piled up relatively thick, on the surface of the material (low-expansion glass, quartz, fine ceramics, etc.), which becomes a preform of a reflection mirror arranged at a position close to the object or the image plane within a projection optical path, the method for intentionally performing an infinitesimal transformation for the shape of a reflection plane in a controllable range by applying a local stress to a preform from the rear or the side of the reflection plane of a reflection mirror, the method for infinitesimally transforming the shape of a reflection plane with thermal expansion by installing a temperature adjuster (Peltier element, heat pipe, etc.) on the rear of a reflection mirror, etc. are considered.

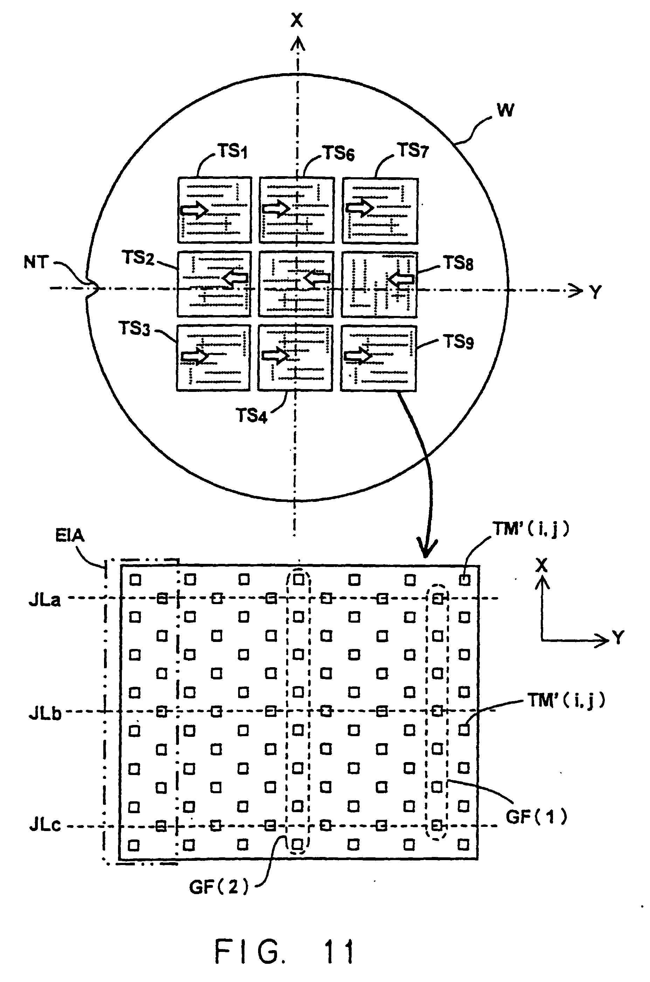

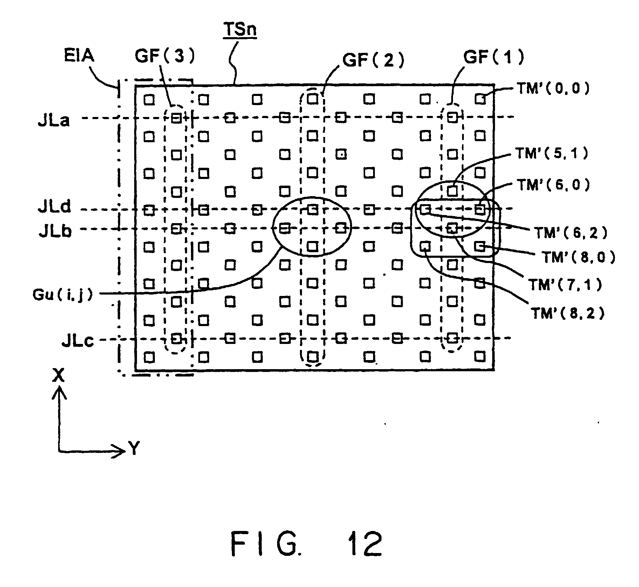

Meanwhile, when the image distortion correction plate G1 is manufactured, when the telecentric correction plate 7N is manufactured, or when the astigmatism/coma aberration correction plate G3 is manufactured, the dynamic distortion characteristic, the dynamic telecentric error characteristic, or the dynamic astigmatism characteristic, etc. in consideration of the averaging at the time of scan-exposure must be obtained by measurements. However, such types of dynamic aberration characteristics can be obtained also from the result of the test printing of a measurement mark pattern on the test reticle TR with a scan-exposure method. Therefore, the measurement method and sequence in that case will be explained below by referring to Figs. 11 and 12.

As explained earlier, if a particular object point positioned on the object plane of the projection optical system PL is transferred on the wafer W by using the exposure apparatus shown in Fig. 1, the image of the object point projected onto the wafer W is modulated by the static distortion characteristic at each position in the scanning direction within the effective projection area EIA of the projection optical system PLM, and is averaged, so that the projection image formed on the wafer W has already included a dynamic distortion characteristic (dynamic image distortion error).

Accordingly, if a measurement mark on the test reticle TR is scan-exposed onto a test wafer, each L&S pattern projection image formed at the position of an ideal lattice point or its equivalent position becomes an image accompanying a dynamic image distortion vector (distortion error).

Therefore, as shown in Fig. 11, a resist layer is coated on a superflat wafer W having a notch NT, which is suitable for test printing, and the wafer is mounted on the table TP of the exposure apparatus shown in Fig. 1. Then, pattern areas on the test reticle TR are sequentially transferred, for example, in 3×3 shot areas TS1 through TS9 on the wafer W with a step-and-scan method. At this time, the respective shot areas TS1 through TS9 shown in Fig. 11 are scanned in an order of TS1, TS2, ..., TS9 alternately in the Y direction as indicated by the arrows in this figure.

As a result, each projection image TM'(i,j) of the test mark TM(i,j) arranged in a matrix state on the test reticle R is transferred in the respective shot areas TS1 to TS9 of the resist layer on the wafer W as a latent image, as expanded and shown in the lower portion of Fig. 11. Then, the wafer W is transmitted to a coater developer, and the resist layer is developed under the condition equal to that at the time of the manufacturing of an actual device.

The developed wafer W is set up within a dedicated examination measurement device, by which a position deviation amount of each projection image TM'(i,j) formed by the concave/convex of the resist layer within the respective shot areas TS1 through TS9 from an ideal lattice point is measured. The projection image TM'(i,j) measured at that time may be any image of an L&S pattern, a cross-shaped LAMPAS mark, a vernier mark, etc., an image suitable for the examination measurement device is used.

For the position deviation measurement of each projection image TM'(i,j) from an ideal lattice point, an alignment detection system included in a projection exposure apparatus may be used. The wafer W after being developed is mounted, for example, within the projection exposure apparatus equipped with an LSA system, an FIA system, or an LIA system, which is disclosed by the Japanese laid-open Publication No. 2-54103, and a pattern and a mark formed on the resist layer can be measured in a similar manner.

The position deviation amount of each projection image TM'(i,j) from an ideal lattice point, which is obtained by the above described measurement operation, becomes an amount that directly represents the dynamic image distortion at each ideal lattice point.

However, respective image distortions of a plurality of projection images TM(i,j), which exist, for example, respectively along lines JLa, JLb, and JLc extending in the scanning direction (X direction), among projection images TM'(i,j) are calculatedly averaged for the respective lines JLa, JLb, and JLc. This is because unevenness occurs due to the move control precision of a reticle stage or a wafer stage at the time of scan-exposure, or a measurement error of a projection image TM'(i,j) if the dynamic image distortion characteristic is determined with only one particular combination.

In this way, the dynamic distortion characteristic at the position in the line JLb within the effective projection area EIA or in its neighborhood can be accurately obtained from the average value of the respective image distortions of the plurality of projection images TM'(i,j) in the line JLb. However, if the respective image distortions of all the projection images TM'(i,j) which exist along the respective lines JLa, JLb, and JLc are averaged within a shot area TSn, also the moving errors (a relative rotation error of a scanning axis, a yawing error, etc.) of the reticle stage 8 and the wafer stage 14 at the time of scan-exposure are averaged in the size of the scanning direction within the shot area TSn.

Therefore, as shown in Fig. 12, the dynamic image distortion is obtained for each of the rightmost combination GF(1), the middle combination GF(2), and the leftmost combination GF(3) in the scanning direction (Y direction) within the shot area TSn by an actual measurement, and the actually measured image distortion from which the moving errors of the stages 8 and 14 at each scanning position (position in the Y direction within the shot area) are subtracted is defined to be a dynamic distortion characteristic.

Then, the distortion characteristics of the respective combinations GF(1), GF(2), and GF(3) from which the moving errors are subtracted are averaged. Notice that it is easy to calculatedly obtain the moving errors of the stages 8 and 14 afterwards, if the measurement value $(X,Y,\theta)$ by the interferometers 46, 62, etc. at the time of scan-exposure is stored in real time in a neighborhood range of the scanning position of each of the combinations GF(1), GF(2), and GF(3).

Additionally, if the dynamic image distortion at an arbitrary position in the X direction is determined in each of the combinations GF(1), GF(2), and GF(3), averaging may be made by using the result of an actual measurement of the image distortion of a projection image TM'(i,j) positioned in the periphery of that position. For example, as shown in Fig. 12, if the image distortion on the line JLb in the combination GF(1) is determined based on the assumption that the upper right corner of the projection image TM'(i,j) is TM'(0,0), the actual measurement values of the image distortions of the projection image TM'(7,1) at that position and its peripheral projection images TM'(6,0), TM'(6,2), TM'(8,0), and TM'(8,2) are averaged.

Similarly, if the image distortion on the line JLd (the position next to the line JLb) in the combination GF(1) is determined, the actual measurement values of the image distortions of the projection images TM'(5,1), TM'(6,0), TM'(6,2), and TM'(7,1), which are positioned in the periphery of that position, are averaged. If the image distortion on the line JLb in the combination GF(2) is determined, the actual measurement values of the image distortions of 4 projection images TM'(i,j) existing in an ellipse Gu(i,j) with that position as a center are averaged.

Furthermore, in this embodiment, a plurality of shot areas TSn are formed on the wafer W. Therefore, if the image distortion on the particular position in the shot area is determined, there is an advantage that a random measurement error can be reduced by adding and averaging the dynamic image distortion (for which a moving error is corrected) at the same position in the other shot areas.

As described above, in this embodiment, a dynamic distortion characteristic is determined based on the result of actual test printing with a scan-exposure method. This method is applicable also to the case where the respective image formation aberration types such as a dynamic telecentric error characteristic, a dynamic astigmatism/coma characteristic, etc. are measured, in exactly the same manner. Additionally, in this embodiment, a dedicated device for examining and measuring mark projection images TM'(i,j) at a plurality of positions on a test-printed wafer, or an alignment system of a projection exposure apparatus is required. However, since the position of a mark projection image which is actually formed on a resist layer, the resolution state of a projection image, the difference due to the directionality of an L&S pattern image, etc. are actually measured, measurements based on the actual optical characteristics of the illumination optical system and the projection optical system PL of the projection exposure apparatus can be made.

The exposure apparatus according to this embodiment is applicable also to an exposure apparatus of a step-and-repeat type, which exposes a pattern of a mask in a state where the mask and a substrate are made stationary, and sequentially step-moves the substrate.

Additionally, as a projection optical system, a material which passes a far-ultraviolet ray through, such as quartz or fluorite, is used as a glass material when the far-ultraviolet light such as an excimer laser, etc. is used. If an $F_2$ laser or an X ray is used, an optical system such as a catadioptric system or a dioptric system can be used. As a reticle, a reflection type my be used.

Furthermore, if a linear motor (refer to USP5,623,853 or USP5,528,118) is used for a wafer stage or a reticle stage, either of an air floating type using an air bearing and a magnetic floating type using Lorentz force or reactance force may be used. Still further, a stage may be of a type moving along a guide or of a guideless type having no guide.

Still further, the repulsion force generated by the moving of a wafer stage may be mechanically freed to a floor (the earth) by using a frame member, as recited in the Japanese laid-open Publication No. 8-166475 (USP5,528,118).

Still further, the repulsion force generated by the moving of a reticle stage may be freed to a floor (the earth) by using a frame member, as recited in the Japanese laid-open Publication No. 8-330224.

Optical adjustments are made by embedding the above described illumination optical system and the projection optical system, which are composed of a plurality of optical elements, wires and pipes are connected after a reticle stage and a wafer stage, which are composed of many mechanical parts, in an exposure apparatus itself, and overall adjustments (electricity adjustment, operation verification, etc.) are further made, so that the exposure apparatus according to this embodiment can be manufactured. It is desirable to manufacture the exposure apparatus in a clean room where the temperature, the degree of cleanliness, etc. are managed.

Still further, a semiconductor device is manufactured by: a step of designing the functionality and the performance of the device; a step of manufacturing a wafer from a silicon material; a step of exposing a reticle pattern onto a wafer with the above described exposure apparatus according to the embodiment; a step of assembling the device (including a dicing process, a bonding process, a packaging process, etc.); and a step of making an examination.

**Industrial Applicability**

As described above, according to the present invention, correction optical members (G1, G3, G4, etc.) which are locally polished to correct dynamic aberration characteristics are inserted in a projection optical path between a mask (reticle R) and a substrate to be exposed (wafer W) by using the dynamic aberration information which is inherent in a scan-exposure apparatus and is added and averaged in the scanning direction, whereby a significantly high aberration correction accuracy at the time of exposure can be obtained.

Accordingly, the accuracy of distortion matching or mixing & matching can be kept to be several to several tens nm, when a plurality of projection exposure apparatuses are mixed and used at the time of overlay and exposure on a manufacturing line of a semiconductor device, whereby a significant effect of improving the yield of semiconductor device manufacturing can be realized.

**Claims**

1. An exposure method transferring a pattern of a mask onto a substrate, comprising:

   arranging the mask on an object plane side of a projection optical system having a predetermined image formation characteristic;
   arranging a photosensitized substrate on an image plane side of the projection optical system;
   restricting a partial image of the mask, which is projected onto the image plane side, to within a projection area having a predetermined width in a one-dimensional scanning direction; and
   performing a scanning exposure of the sensitized substrate by moving the mask and the substrate in a state where at least one correction optical element, which is optically processed so that an average aberration characteristic obtained by averaging projection aberrations of respective images at a plurality of image points existing along the scanning direction in the projection area become a predetermined state respectively at a plurality of positions in a non-scanning direction intersecting the scanning direction of the projection area, is arranged in an optical path for imaging by the projection optical system.

2. The method according to claim 1, wherein the correction optical element is made of a transparent optical glass material arranged at least one of the object plane side and the image plane side, and a surface portion corresponding to the projection area of the transparent optical glass material is optically processed to be a locally different plane shape so that the averaged projection aberrations respectively at the plurality of positions in the non-scanning direction become almost identical.

3. The method according to claim 1, wherein the optical correction element includes a correction plate for correcting a dynamic projection aberration characteristic occurring at the time of said scannin exposure.

4. The method according to claim 1, wherein the optical correction element includes an image correction plate for correcting a distortion characteristic, which is arranged on the object plane side of the projection optical system.

5. The method according to claim 1, wherein the optical correction element includes an astigmatism correction plate for correcting an astigmatism aberration characteristic, which is arranged on the image plane side of the projection optical system.

6. The method according to claim 1, wherein the optical correction element includes a coma correction plate which is arranged on the image plane side of the projection optical system, and corrects a coma aberration characteristic.

7. The method according to claim 1, wherein the optical correction element includes an image plane curvature correction plate which is arranged on the image plane side of the projection optical system, and corrects an image plane curvature characteristic.

8. The method according to claim 1, wherein the scanning exposure of the substrate is performed while projecting an image of the pattern of the mask onto the substrate through the projection optical system in a state where an illumination aberration correction member for correcting an optical aberration of an illumination light irradiated on the mask is arranged in an optical path of the illumination light.

9. The method according to claim 8, wherein the illumination aberration correction member corrects an aberration caused by at least one of an entire telecentric error of an illumination light irradiated on the mask or a test reticle, a local telecentric error of the illumination light, and an error of an illumination numerical aperture varying according to a position within a field of the projection optical system.

10. The method according to claim 1, wherein the projection aberration is measured by using an image detector which is attached to part of a substrate stage that supports the sensitized substrate and can move, and comprises an small aperture receiving a projection image of a measurement mark of a test reticle arranged on the object plane side of the projection optical system.

11. An exposure method in which a substrate is exposed by projecting an image of a pattern of a mask onto the substrate through a projection optical system, comprising:

arranging the mask and the substrate; and projecting the image of the pattern of the mask through the projection optical system in a state where a coma correction plate respectively correcting random coma characteristics of respective images at a plurality of positions within a projection area of the projection optical system is arranged between the mask and the substrate.

12. The method according to claim 11, wherein a surface portion of the coma correction plate, which corresponds to the projection area, is optically processed to be a predetermined shape in a local manner, so that the random coma characteristics of the respective images at the plurality of positions within the projection area are respectively corrected.

13. The method according to claim 12, wherein:

a coma characteristic of a projection image at each of a plurality of positions within the projection area is measured; and the coma correction plate is optically processed based on a measurement result.

14. The method according to claim 11, wherein:

a scanning exposure of the substrate is performed by synchronously moving the mask and the substrate relative to the projection optical system; and the coma correction plate corrects a dynamic coma characteristic occurring during the scanning exposure.

15. An exposure method in which a substrate is exposed by projecting an image of a pattern of a mask onto the substrate through a projection optical system, comprising:

arranging the mask and the substrate; and projecting the image of the pattern of the mask through the projection optical system in a state where an astigmatism correction plate respectively correcting random astigmatism characteristics of respective images at a plurality of positions within a projection area of the projection optical system is arranged between the mask and the substrate.

16. The method according to claim 15, wherein a surface portion of the astigmatism correction plate, which corresponds to the projection area, is optically processed to be a predetermined shape in a local manner, so that the random astigmatism characteristics of the respective images at the plurality of positions within the projection area are respectively corrected.

17. The method according to claim 16, wherein:

an astigmatism characteristic of a projection image at each of a plurality of positions within the projection area is measured; and the astigmatism correction plate is optically processed based on a measurement result.

18. The method according to claim 15, wherein:

a scanning exposure of the substrate is performed by synchronously moving the mask and the substrate relative to the projection optical system; and

the astigmatism correction plate corrects a dynamic astigmatism characteristic occurring during the scanning exposure.

19. An exposure apparatus exposing a substrate by projecting an image of a pattern of a mask onto the substrate, comprising:

a projection optical system, which is arranged between the mask and the substrate, projecting the image of the pattern of the mask onto the substrate; and
an astigmatism correction plate correcting a non-linear astigmatism characteristic at each image at a plurality of positions within a projection area of said projection optical system.

20. The exposure apparatus according to claim 19, further comprising

a measurement device, which is arranged on an image plane side of said projection optical system, measuring an astigmatism characteristic at each of a plurality of positions within the projection area.

21. The exposure apparatus according to claim 19, further comprising

an image plane curvature correction member, which is arranged between the mask and the substrate, correcting non-linear image plane curvature occurring at each of a plurality of positions within the projection area of said projection optical system.

22. The exposure apparatus according to claim 19, further comprising

a distortion correction member, which is arranged between the mask and the substrate, respectively correcting non-linear distortions of respective images at a plurality of positions within the projection area of said projection optical system.

23. An exposure apparatus exposing a substrate by projecting an image of a pattern of a mask onto the substrate, comprising:

a projection optical system, which is arranged between the mask and the substrate, projecting the image of the pattern of the mask onto the substrate; and
a coma correction plate, which is arranged between the mask and the substrate, correcting a non-linear coma characteristic of each image at a plurality of positions within the projection area of said projection optical system.

24. The exposure apparatus according to claim 23, further comprising

a measurement device, which is arranged on an image plane side of said projection optical system, measuring a coma characteristic of a projection image at each of a plurality of positions within the projection area.

25. The exposure apparatus according to claim 23, further comprising

an image plane curvature correction member, which is arranged between the mask and the substrate, correcting non-linear image plane curvature at each of a plurality of positions within the projection area of said projection optical system.

26. The exposure apparatus according to claim 23, further comprising

a distortion correction member, which is arranged between the mask and the substrate, respectively correcting non-linear distortions of respective projection images at a plurality of positions within the projection area of said projection optical system.

FIG. 1

F I G. 2

F I G. 3

FIG. 4

FIG. 5

(A)

(B)

# FIG. 6

FIG. 7

PULSE ILLUMINATION LIGHT
FROM FIRST FLYEYE LENS 7C

DFx

7F

Z

X

SGa

SGb

AX

SGa

X

SGb

X

(A)

7G

SGb

SGa

X

Y

(B)

FIG. 8

FIG. 9

FIG. 10

F I G.  11

FIG. 12

<div align="center">

**INTERNATIONAL SEARCH REPORT**

</div>

| International application No. |
| --- |
| PCT/JP98/03305 |

**A. CLASSIFICATION OF SUBJECT MATTER**
Int.Cl⁶ H01L21/027, G03F7/20

According to International Patent Classification (IPC) or to both national classification and IPC

**B. FIELDS SEARCHED**

Minimum documentation searched (classification system followed by classification symbols)
Int.Cl⁶ H01L21/027, G03F7/20

Documentation searched other than minimum documentation to the extent that such documents are included in the fields searched
Jitsuyo Shinan Koho          1972-1995
Kokai Jitsuyo Shinan Koho    1972-1995

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP, 9-92601, A (Nikon Corp.), 4 April, 1997 (04. 04. 97), Column 3, line 20 to column 11, line 4 ; column 14, line 45 to column 15, line 1 (Family: none) | 1, 2, 4, 10 |
| A | JP, 8-288192, A (Nikon Corp.), 1 November, 1996 (01. 11. 96), Claims (Family: none) | 1-26 |
| A | JP, 8-124831, A (Toshiba Corp.), 17 May, 1996 (17. 05. 96), Column 4, line 20 to column 8, line 13 (Family: none) | 1-26 |
| A | JP, 8-8157, A (Nikon Corp.), 12 January, 1996 (12. 01. 96), Claims (Family: none) | 1-26 |
| A | JP, 7-66110, A (Toshiba Corp.), 10 March, 1995 (10. 03. 95), Column 4, line 25 to column 10, line 8 (Family: none) | 1-26 |

| [X] Further documents are listed in the continuation of Box C. | [ ] See patent family annex. |
| --- | --- |

\*     Special categories of cited documents:
"A"  document defining the general state of the art which is not considered to be of particular relevance
"E"  earlier document but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
| --- | --- |
| 20 October, 1998 (20. 10. 98) | 27 October, 1998 (27. 10. 98) |

| Name and mailing address of the ISA/ Japanese Patent Office | Authorized officer |
| --- | --- |
| Facsimile No. | Telephone No. |

Form PCT/ISA/210 (second sheet) (July 1992)

INTERNATIONAL SEARCH REPORT

| International application No. |
| --- |
| PCT/JP98/03305 |

C (Continuation). DOCUMENTS CONSIDERED TO BE RELEVANT

| Category* | Citation of document, with indication, where appropriate, of the relevant passages | Relevant to claim No. |
| --- | --- | --- |
| PA | JP, 10-27743, A (Canon Inc.), 27 January, 1998 (27. 01. 98), Column 5, line 25 to column 7, line 20 (Family: none) | 1-26 |

Form PCT/ISA/210 (continuation of second sheet) (July 1992)